(19) Europäisches Patentamt / European Patent Office / Office européen des brevets

(11) **EP 2 904 384 B1**

(12) **FASCICULE DE BREVET EUROPEEN**

(45) Date de publication et mention de la délivrance du brevet:
**16.11.2016 Bulletin 2016/46**

(21) Numéro de dépôt: **13774121.1**

(22) Date de dépôt: **02.10.2013**

(51) Int Cl.:
*G01N 30/64* (2006.01)     *B81B 7/04* (2006.01)
*G01L 1/18* (2006.01)     *H03H 3/007* (2006.01)
*H03H 9/02* (2006.01)

(86) Numéro de dépôt international:
**PCT/EP2013/070594**

(87) Numéro de publication internationale:
**WO 2014/053575 (10.04.2014 Gazette 2014/15)**

(54) **SYSTEME DE MESURE COMPRENANT UN RESEAU DE RESONATEURS DE TYPE NANO-SYSTEME ELECTROMECANIQUE**

MESSSYSTEM MIT EINEM NANO-ELEKTROMECHANISCHEN RESONATOREN-ARRAY

MEASURING SYSTEM COMPRISING A NANO-ELECTROMECHANICAL RESONATOR ARRAY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.10.2012 FR 1259339**

(43) Date de publication de la demande:
**12.08.2015 Bulletin 2015/33**

(73) Titulaires:
- **Commissariat à l'Énergie Atomique et aux Énergies Alternatives**
  **75015 Paris (FR)**
- **Apix Analytics**
  **38000 Grenoble (FR)**

(72) Inventeurs:
- **ANDREUCCI, Philippe**
  **F-38430 Moirans (FR)**
- **BARATTIN, Régis**
  **F-38000 Grenoble (FR)**
- **COLINET, Eric**
  **F-76230 Bois Guillaume (FR)**
- **DURAFFOURG, Laurent**
  **F-38500 Voiron (FR)**
- **PUGET, Pierre**
  **F-30330 Saint Ismier (FR)**

(74) Mandataire: **Regimbeau**
  **139, rue Vendôme**
  **69477 Lyon Cedex 06 (FR)**

(56) Documents cités:
**EP-A2- 2 008 965     US-A1- 2009 153 258**
**US-B1- 7 750 759**

- **I. BARGATIN ET AL: "Large-Scale Integration of Nanoelectromechanical Systems for Gas Sensing Applications", NANO LETTERS, vol. 12, no. 3, 14 mars 2012 (2012-03-14), pages 1269-1274, XP055047111, ISSN: 1530-6984, DOI: 10.1021/nl2037479 cité dans la demande**

**Description**

**DOMAINE DE L'INVENTION**

La présente invention concerne un système de mesure comprenant un réseau de résonateurs de type nano-système électromécanique (NEMS).

**ARRIERE PLAN DE L'INVENTION**

Les résonateurs de type nano-système électromécanique (généralement désignés par l'acronyme NEMS, du terme anglo-saxon « Nano Electro Mechanical System ») sont des dispositifs prometteurs notamment dans le domaine de l'analyse de gaz.

Le principe de détection d'une espèce contenue dans un échantillon dudit gaz repose sur l'actionnement, par un signal d'excitation (mécanique ou électrique), d'une poutre suspendue de dimensions nanométriques à sa fréquence de résonance, et la détection du déplacement de ladite poutre au moyen d'au moins une jauge de contrainte.

La poutre étant fonctionnalisée par une substance chimique déterminée, le passage d'un échantillon de gaz dans un canal fluidique dans lequel est placé le résonateur permet la capture (par exemple par adsorption) par ladite substance de molécules d'une espèce contenue dans l'échantillon.

La capture d'au moins une molécule a pour effet de modifier la fréquence de résonance de la poutre, qui est détectable dans le signal de sortie (généralement électrique) de la jauge de contrainte.

Le résonateur est connecté à un circuit électronique de lecture, qui permet d'une part l'actionnement de la poutre en vibration par le signal d'excitation et d'autre part la lecture du signal de sortie émis par la jauge de contrainte.

Différentes structures de résonateurs ont déjà été conçues, comprenant différents types de poutres (encastrée-libre, encastrée-encastrée,...), des moyens d'actionnement divers (incluant des moyens d'actionnement thermoélastique, électrostatique...) et des techniques de détection variées (incluant des moyens piézorésistifs, piézoélectriques...).

De tels résonateurs peuvent être fabriqués sur des substrats de silicium au moyen des techniques habituelles de la micro-électronique, incluant des procédés de gravure, de dépôt, etc.

Cependant, en raison de leur taille nanométrique, les résonateurs NEMS sont relativement fragiles (notamment en termes de chocs mécaniques et électriques).

Par ailleurs, leur faible surface rend difficile la capture d'espèces contenues dans des concentrations très faibles dans les échantillons à analyser.

Pour pallier ces limitations, il peut être avantageux d'utiliser simultanément plusieurs résonateurs de ce type, agencés en réseau.

Les avantages attendus d'un réseau de résonateurs NEMS sont multiples.

D'une part, ils offrent une surface totale pour la capture des espèces à analyser qui est d'autant plus grande que le nombre de poutres est élevé.

Ceci permet de détecter plus finement des espèces contenues en faible concentration dans l'échantillon gazeux à analyser.

Par ailleurs, l'utilisation d'un réseau de résonateurs NEMS permet de minimiser l'impact de la défaillance de l'un d'entre eux, qui est compensée par le fonctionnement des autres résonateurs du réseau, améliorant ainsi la robustesse du dispositif.

En outre, pour un réseau de N résonateurs NEMS, on devrait atteindre, en théorie, un gain en limite de détection de l'ordre de $\sqrt{N}$ en termes de signal (ou de l'ordre de N en termes de puissance).

La limite de détection peut être estimée par le calcul de la variance d'Allan, qui exprime la résolution de mesure en fréquence (rapport df/f) en fonction du temps de mesure (également désigné par le terme « temps d'intégration »).

L'obtention d'un tel gain de $\sqrt{N}$ peut être désignée par le terme d' « effet réseau ».

Cependant, la réalisation d'un réseau de résonateurs NEMS se heurte à différentes difficultés technologiques, de sorte qu'il n'a pas encore été possible, à ce jour, de fabriquer de réseau permettant d'obtenir l'effet réseau attendu.

Ainsi, l'article de Bargatin et al. [Bargatin2012] décrit un réseau de 2800 résonateurs NEMS connectés en série et en parallèle, dans lequel chaque résonateur comprend une poutre en silicium encastrée-libre associée à une jauge de contrainte piézorésistive constituée d'une couche métallique déposée sur la poutre, la poutre étant actionnée thermoélastiquement de sorte à vibrer hors du plan du substrat dans lequel elle est fabriquée.

L'actionnement thermoélastique repose sur l'application au résonateur d'une tension alternative à une fréquence engendrant des variations de température de la poutre à sa fréquence de résonance.

Pour s'affranchir du bruit de fond, les auteurs ont mis en oeuvre une mesure différentielle consistant à connecter deux réseaux identiques à la même entrée de l'électronique de lecture, mais en appliquant un déphasage de 180° au signal envoyé à l'un des réseaux par rapport à l'autre, et en sommant les signaux de sortie de chacun des réseaux.

Cet article met cependant en évidence des résultats décevants en termes de limite de détection, notamment pour des temps d'intégration longs, c'est-à-dire supérieurs à 100 ms.

Ainsi, une limite de détection comparable à celle d'un résonateur individuel a été constatée pour des temps d'intégration de l'ordre de quelques secondes.

D'après les auteurs de l'article, ces résultats semblent s'expliquer par des problèmes de dispersion des fréquences de résonance entre résonateurs.

En effet, l'effet réseau mentionné plus haut ne peut être obtenu que dans des conditions idéales, comprenant notamment l'hypothèse que les résonateurs du réseau sont parfaitement identiques les uns aux autres.

En pratique, ces conditions sont difficiles à atteindre dans la mesure où, notamment, les dispersions de fabrication d'un résonateur à l'autre sont inévitables.

Ainsi, [Bargatin2012] indique que le réseau utilisé dans l'expérience présente des dispersions des fréquences de résonance, imputables aux dispersions de fabrication, de l'ordre de 1%.

Il en résulte que les résonateurs dont la réponse est trop différente de celle des autres résonateurs du réseau ne participent pas à la mesure, de sorte que, bien que la limite de détection puisse être diminuée, l'effet réseau ne peut être atteint.

L'article de Mile et al. [Mile2010] présente un exemple d'un résonateur NEMS différent de ceux employés dans [Bargatin2012].

Ce résonateur comprend une poutre suspendue encastrée-libre, de part et d'autre de laquelle s'étendent deux jauges de contrainte piézorésistives en silicium dopé.

L'actionnement de la poutre est réalisé de manière électrostatique, par deux électrodes disposées de part et d'autre de la poutre, conduisant à une vibration de la poutre dans le plan du substrat dans lequel elle est fabriquée.

Cependant, bien que ce type de résonateur, qui n'a été testé qu'individuellement, paraisse prometteur en termes de rapport signal sur bruit, la variance d'Allan mesurée reste inexplicablement plus élevée que la variance théorique en raison d'un bruit inconnu dont la nature n'a pas été identifiée à ce jour.

Or, l'existence de ce bruit non identifié est susceptible d'empêcher l'obtention d'un effet réseau si l'on tentait d'associer lesdits résonateurs en réseau.

En effet, si ce bruit est extrinsèque aux résonateurs, ou s'il est intrinsèque aux résonateurs mais corrélé d'un résonateur à l'autre, un effet réseau ne peut être obtenu.

Il reste donc à remédier à ces phénomènes pour pouvoir réaliser un réseau de résonateurs permettant effectivement d'obtenir l'effet réseau recherché.

Par ailleurs, seul un adressage collectif des résonateurs est proposé dans [Bargatin2012], c'est-à-dire que l'ensemble des résonateurs est relié à une même entrée et une même sortie, de sorte qu'il n'est pas possible de lire le signal de sortie de chaque résonateur.

En d'autres termes, le signal de sortie du réseau correspond à la moyenne des signaux des différents résonateurs.

Or, il peut être intéressant d'adresser les résonateurs individuellement, c'est-à-dire de lire le signal de sortie de chaque résonateur.

Cependant, un résonateur NEMS présente au moins deux, voire quatre plots d'interconnexion avec son électronique de lecture. Ainsi, pour des résonateurs du type décrit dans [Mile2010], lorsque l'on découple le mode d'actionnement et le mode de détection, c'est-à-dire que l'on emploie des moyens différents pour actionner la poutre d'une part et détecter son déplacement d'autre part, au moins deux plots sont nécessaires à la connexion du résonateur à un circuit d'actionnement et au moins deux autres plots sont nécessaires à la connexion à un circuit de détection.

Par conséquent, un adressage individuel des résonateurs supposerait de multiplier ce nombre de plots d'interconnexion par le nombre de résonateurs, ce qui, pour un nombre élevé de résonateurs, est techniquement impossible compte tenu des contraintes relatives à la taille globale des dispositifs.

US7750759 (RF MICRO DEVICES INC, published 06-07-2010) divulgue système de mesure multi-mode comprenant un réseau de résonateurs de type micro-système électromécanique (MEMS).

US2009/153258 (Robert Bosch GmbH, published 18-06-2009) divulgue un système de mesure comprenant un réseau de résonateurs de type micro-système électromécanique (MEMS).

Un but de l'invention est donc de concevoir un système de mesure comprenant des résonateurs NEMS présentant des performances améliorées en termes de limite de détection et bénéficiant autant que possible de l'effet réseau attendu.

Un autre but de l'invention est de concevoir un système de mesure susceptible d'être fabriqué selon un procédé peu complexe et permettant l'obtention d'un système de faibles dimensions.

## BREVE DESCRIPTION DE L'INVENTION

Conformément à l'invention, il est proposé un système de mesure comprenant un réseau de résonateurs de type nano-système électromécanique (NEMS), caractérisé en ce que:

- chacun desdits résonateurs comprend :

    - une entrée pour recevoir un signal d'excitation et une sortie pour fournir un signal de sortie en réponse audit signal d'excitation, ledit signal de sortie présentant une résonance à la fréquence de résonance du résonateur,
    - une poutre suspendue par rapport à un support, la fréquence de résonance à vide du résonateur correspondant à la fréquence de résonance à vide de ladite poutre,
    - un dispositif d'actionnement électrostatique apte à générer une vibration de ladite poutre sous l'effet dudit signal d'excitation,
    - au moins une jauge de contrainte piézorésistive en matériau semi-conducteur dopé, suspendue par rapport audit support et s'étendant à partir de la poutre de sorte à détecter un déplacement de ladite poutre, la variation de résistance électrique de ladite au moins une jauge fournissant ledit signal de sortie,

- ledit réseau comprend au moins deux groupes de résonateurs, chaque groupe comprenant au moins deux résonateurs présentant une fréquence de résonance à vide identique, chaque groupe de résonateurs présentant une fréquence de résonance à vide différente de celle de chaque autre groupe,
- le système comprend une mémoire dans laquelle est enregistrée une information relative à la fréquence de résonance à vide de chaque résonateur ou groupe de résonateurs,
- les résonateurs formant chaque groupe sont connectés en parallèle, chaque groupe comprenant une entrée et une sortie connectées respectivement à l'entrée et à la sortie de chacun desdits résonateurs,
- les groupes de résonateurs formant ledit réseau sont connectés en parallèle, ledit réseau comprenant une entrée et une sortie connectées respectivement à l'entrée et à la sortie de chacun desdits groupes de résonateurs,
- ledit système comprend un dispositif de lecture conçu pour fournir un signal d'excitation à l'entrée du réseau et pour déterminer la fréquence de résonance d'un groupe de résonateurs sélectionné en injectant dans ledit signal d'excitation une composante fréquentielle correspondant à la fréquence de résonance à vide mémorisée pour chaque groupe de résonateurs sélectionné et en identifiant, dans le signal de sortie du réseau, une composante fréquentielle de résonance du groupe de résonateurs sélectionné.

Par « réseau », on entend dans le présent texte un agencement dense d'au moins deux groupes de résonateurs NEMS connectés en parallèle.

Par «dense», on entend une densité d'au moins 100 résonateurs / mm$^2$, de préférence supérieure ou égale à 1000 résonateurs / mm$^2$.

De la sorte, tous les résonateurs du réseau sont soumis simultanément au même environnement et en particulier au même échantillon de gaz à analyser.

A cet égard, on notera que le document WO 2011/154363 dans lequel est décrit l'agencement d'une pluralité de résonateurs NEMS (désigné par le terme « network »), ne porte pas sur un réseau au sens de la présente invention.

En effet, contrairement à la présente invention, qui veille à mettre en contact tous les résonateurs d'un réseau en contact avec le même échantillon à analyser, le document précité vise à distribuer temporellement et spatialement l'échantillon gazeux à analyser par la pluralité de résonateurs.

Ledit système peut comprendre un dispositif de sommation des signaux de sortie de chaque groupe de résonateurs du réseau en un signal total de sortie du réseau et le dispositif de lecture est conçu pour déterminer la fréquence de résonance d'un groupe de résonateurs à partir dudit signal total de sortie du réseau.

De manière avantageuse, ledit dispositif de lecture comprend un circuit à boucle de phase asservie (PLL) conçu pour caler une fréquence du signal d'excitation sur la fréquence d'un pic de résonance du signal de sortie du réseau et pour fournir, en tant que fréquence de résonance d'excitation, la fréquence calée.

Selon un mode de réalisation, chaque groupe de résonateurs est fonctionnalisé avec une espèce chimique différente.

Selon une forme d'agencement du réseau, les résonateurs du réseau sont agencés sur un même support de sorte à former des lignes et des colonnes de résonateurs s'étendant parallèlement les uns aux autres, les poutres des résonateurs étant parallèles les unes aux autres.

Selon une autre forme d'agencement, les résonateurs du réseau sont agencés sur un même support de sorte à former des lignes et des colonnes de résonateurs s'étendant parallèlement les uns aux autres, lesdits résonateurs étant en outre agencés de sorte que, sur une même ligne parallèle aux poutres des résonateurs, deux résonateurs adjacents soient symétriques par rapport à un plan parallèle à une colonne.

De préférence, le système comprend au moins un canal fluidique destiné à l'écoulement d'un échantillon gazeux à analyser, ledit réseau de résonateurs étant agencé dans ledit canal fluidique de sorte que les poutres desdits résonateurs soient exposées audit échantillon.

Le système peut par ailleurs comprendre au moins deux réseaux de résonateurs dans ledit canal fluidique.

Selon une forme d'exécution avantageuse, le système comprend au moins un résonateur dit de référence agencé hors du canal fluidique tout en étant soumis aux mêmes fluctuations externes, et connecté au même dispositif de lecture que le réseau agencé dans le canal fluidique ; le système comprend en outre un système de traitement configuré pour combiner le signal de sortie dudit résonateur de référence avec les signaux de sortie des groupes de résonateurs du réseau.

Selon une autre forme d'exécution avantageuse, le système comprend au moins un résonateur dit de référence configuré pour être moins sensible à l'échantillon gazeux que les autres groupes de résonateurs et en ce que le système comprend un système de traitement configuré pour combiner le signal de sortie dudit résonateur de référence avec les signaux de sortie des groupes de résonateurs du réseau.

Le système peut également comprendre un système de traitement configuré pour combiner les signaux de sortie de chaque groupe de résonateurs du réseau avec une moyenne desdits signaux.

Par ailleurs, le système peut comprendre une colonne de chromatographie en phase gazeuse contenant ledit canal fluidique.

De manière avantageuse, le canal de ladite colonne de chromatographie comprend une pluralité de réseaux de résonateurs distribués régulièrement entre l'entrée et la sortie de ladite colonne.

De manière alternative, le système peut comprendre une colonne de chromatographie en phase gazeuse en amont dudit canal fluidique dans la direction d'écoulement de l'échantillon gazeux.

Un autre aspect de l'invention se rapporte à un procédé de lecture d'un système tel que décrit ci-dessus, caractérisé en ce qu'il comprend les étapes consistant à :

- sélectionner, parmi les groupes de résonateurs du réseau, un groupe de résonateurs à lire,
- récupérer dans la mémoire l'information de résonance à vide de chaque groupe de résonateurs sélectionné,
- appliquer un signal d'excitation au réseau comprenant une composante fréquentielle correspondant à la fréquence de résonance à vide de chaque groupe de résonateurs sélectionné,
- déterminer la fréquence de résonance de chaque groupe de résonateurs sélectionné en identifiant, dans le signal de sortie du réseau, une composante fréquentielle de résonance de chaque groupe de résonateurs sélectionné.

Ainsi, de préférence, l'application dudit signal d'excitation génère dans le signal de sortie une composante fréquentielle principale correspondant à la résonance de chaque groupe de résonateurs sélectionné, et l'on détermine la fréquence de résonance de chaque groupe de résonateurs sélectionné en extrayant ladite composante fréquentielle du signal de sortie du réseau.

Un autre aspect de l'invention concerne un procédé de fabrication d'un système tel que décrit plus haut, caractérisé en ce qu'il comprend la fabrication collective, sur un support en un matériau semi-conducteur, des résonateurs formant ledit réseau en mettant en oeuvre des techniques de microélectronique.

De manière avantageuse, ledit procédé comprend la fonctionnalisation collective des groupes de résonateurs dudit réseau par dépôt chimique en phase vapeur (CVD) ou dépôt physique en phase vapeur (PVD) d'espèces chimiques différentes pour chacun desdits groupes.

**BREVE DESCRIPTION DES DESSINS**

D'autres caractéristiques et avantages de l'invention ressortiront de la description détaillée qui va suivre, en référence aux dessins annexés sur lesquels :

- la figure 1 est un schéma en vue de dessus d'un mode de réalisation d'un résonateur NEMS faisant partie d'un système selon l'invention ;
- la figure 2 est une représentation schématique de la variance d'Allan pour un résonateur individuel et pour un réseau de résonateurs selon l'art antérieur ;
- la figure 3A est un schéma en vue de dessus d'un premier exemple d'agencement dense de résonateurs NEMS en réseau ;
- la figure 3B est un schéma en vue de dessus d'un deuxième exemple d'agencement de résonateurs NEMS en réseau, procurant une densité plus grande par rapport à celle de l'exemple de la figure 3A ;
- la figure 4 est un schéma en vue de dessus de la connexion des différents résonateurs du réseau ;
- la figure 5 illustre de manière schématique en vue de dessus l'agencement d'un réseau constitué de 5 groupes de résonateurs dans un canal fluidique ;

- la figure 6 est un schéma de l'architecture électronique de lecture d'un tel réseau ;
- la figure 7 présente la variance d'Allan mesurée pour un réseau de 4 résonateurs ;
- la figure 8 présente la densité spectrale de puissance des signaux de chacun des résonateurs et d'un signal reconstruit par fusion desdits signaux ;
- la figure 9 présente la variance d'Allan des signaux de chacun des résonateurs et du signal reconstruit par fusion desdits signaux ;
- la figure 10 présente la variance d'Allan mesurée pour un réseau de 45 résonateurs, et pour un signal reconstruit à partir desdits signaux ;
- la figure 11 présente la variance d'Allan mesuré pour un réseau de 16 résonateurs, et pour un signal reconstruit à partir desdits signaux,
- la figure 12 présente la variance d'Allan mesurée pour un groupe de 75 résonateurs et pour un résonateur unitaire,
- les figures 13A et 13B présentent des signaux de détection de pics de toluène mesurés respectivement par un résonateur unitaire et par un groupe de 75 résonateurs ; la figure 13C présentant la superposition de ces deux signaux.

## DESCRIPTION DETAILLEE DE MODES DE REALISATION DE L'INVENTION

On va décrire successivement les différents éléments du système, puis l'on décrira le fonctionnement dudit système.

### Description d'un mode de réalisation d'un résonateur

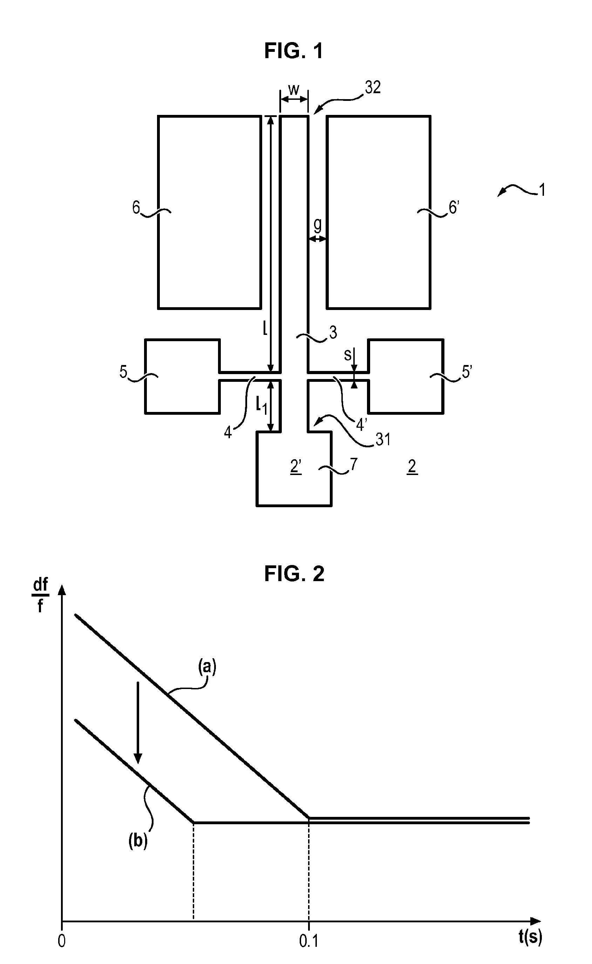

La figure 1 présente en vue de dessus un résonateur selon un mode de réalisation de l'invention.

Ledit résonateur 1 est formé sur un substrat support 2.

Le résonateur comprend une poutre 3 de longueur L et de largeur w.

La poutre 3 est suspendue par rapport au substrat support 2, à l'exception d'un encastrement de l'une de ses extrémités 31 dans une partie 2' du substrat, en saillie par rapport au plan du substrat 2 qui s'étend sous la poutre 3.

De manière connue en elle-même, une telle poutre peut être formée par gravure du substrat 2.

L'autre extrémité 32 de la poutre est quant à elle libre.

De part et d'autre de la poutre 3 s'étendent deux jauges de contrainte piézorésistives 4, 4', qui sont également suspendues par rapport au substrat 2.

Avantageusement, lesdites jauges 4, 4' sont, comme la poutre, gravées dans le substrat 2 et présentent au moins un plan en commun avec la poutre 3.

Ces jauges sont en matériau semi-conducteur dopé, présentant de préférence une concentration en dopants supérieure à $10^{19}$ atomes/cm$^3$ et présentent une section s.

Selon un mode de réalisation donné à titre indicatif, la largeur d'une jauge est de 100 nm, son épaisseur de 160 nm et sa longueur de 500 nm.

De préférence, ledit matériau semi-conducteur dopé est du silicium dopé.

L'intersection entre chacune des jauges 4, 4' et la poutre 3 se trouve à une distance $l_1$ de la région 31 d'encastrement de la poutre, choisie pour maximiser la contrainte exercée sur la jauge lors de la déflexion de la poutre.

Chacune des jauges 4, 4' est reliée à une électrode 5, 5', lesdites électrodes permettant l'application respectivement de potentiels constants de signes opposés.

Dans d'autres modes de réalisation du résonateur, il est possible de n'employer qu'une jauge de contrainte en matériau semi-conducteur dopé.

Le résonateur 1 comprend en outre un dispositif d'actionnement électrostatique de la poutre qui, comme représenté ici, peut comprend deux électrodes 6, 6' s'étendant dans le plan même plan que la poutre et sont disposées de part et d'autre de celle-ci, à une distance g.

Les électrodes 6, 6' sont destinées à recevoir respectivement un signal électrique d'excitation et un signal de signe opposé, et constituent donc deux entrées du résonateur.

Sous l'application d'un signal électrique présentant une fréquence correspondant à la fréquence de résonance à vide de la poutre 3, la poutre est entraînée en vibration dans un plan parallèle au substrat 2.

Par fréquence de résonance à vide de la poutre, on entend la fréquence de résonance de la poutre en l'absence de l'échantillon de gaz à analyser.

Selon une forme d'exécution, la mesure de la variation de résistance électrique des jauges piézorésistives est effectuée entre l'extrémité encastrée 31 de la poutre et la jonction entre la poutre et les jauges 4, 4'.

Le signal de sortie du résonateur est ainsi fourni à une électrode 7 de connexion située au niveau de l'extrémité encastrée 31 de la poutre, en vue de la lecture dudit signal.

Cette méthode de mesure n'est cependant pas exclusive et le signal de sortie peut être fourni par d'autres moyens ; par exemple, il est possible d'appliquer une tension de polarisation au niveau de l'électrode 7 et de mesurer la tension aux bornes de l'ensemble des deux jauges 4,4' pour en déduire la variation de leur résistance électrique

L'homme du métier pourra donc ajuster la conception de la polarisation de la(les) jauge(s) de contrainte et de la mesure de leur réponse sans pour autant sortir du cadre de la présente invention.

A titre purement indicatif, les dimensions de la poutre d'un tel résonateur sont de l'ordre de quelques micromètres en longueur, de quelques centaines de nanomètres en largeur, et d'une centaine de nanomètres d'épaisseur.

Ainsi, selon un mode de réalisation donné à titre d'exemple, la poutre présente une longueur de 3 à 4 μm, une largeur de 300 nm et 160 nm d'épaisseur.

On pourra également se référer aux documents [Mile2010] et EP 2 008 965, qui décrivent un tel résonateur.

Cependant, cette forme de réalisation du résonateur n'est pas limitative et l'on trouvera dans les documents WO 2012/034990 et WO 2012/034951 d'autres exemples de résonateurs susceptibles d'être mis en oeuvre dans un système selon l'invention, présentant notamment différents modes d'encastrement de la poutre.

Tous ces modes de réalisation des résonateurs ont en commun au moins les caractéristiques suivantes :

- une entrée pour recevoir un signal d'excitation et une sortie pour fournir un signal de sortie en réponse audit signal d'excitation, ledit signal de sortie présentant une résonance à la fréquence de résonance du résonateur,
- une poutre suspendue par rapport à un support, la fréquence de résonance à vide du résonateur étant définie comme étant la fréquence de résonance à vide de ladite poutre,
- un dispositif d'actionnement électrostatique apte à générer une vibration de ladite poutre sous l'effet dudit signal d'excitation,
- au moins une jauge de contrainte piézorésistive en matériau semi-conducteur dopé, suspendue par rapport audit support et s'étendant à partir de la poutre de sorte à détecter un déplacement de ladite poutre, la variation de résistance électrique de ladite au moins une jauge fournissant ledit signal de sortie.

De tels résonateurs présentent en effet les avantages suivants.

D'une part, l'utilisation d'une force électrostatique permet de réduire de manière substantielle la puissance nécessaire pour actionner un résonateur (qui est de l'ordre d'1 microwatt ou moins), ce qui réduit les contraintes sur l'électronique d'interface.

A titre de comparaison, on peut estimer à 1 milliwatt la puissance nécessaire pour actionner un résonateur de manière thermoélastique, comme dans [Bargatin2012].

A cet égard, les inventeurs ont identifié comme une des causes possibles des performances décevantes du réseau décrit dans ce document la nécessité d'une électronique d'interface très complexe et susceptible de ne pas être capable de délivrer la puissance requise pour l'ensemble des résonateurs du réseau.

De ce fait, ces résonateurs semblent ne pas avoir été actionnés de manière suffisante pour que leur signal électrique de sortie soit nettement supérieur au bruit de l'électronique de lecture.

Par conséquent, la source de bruit prédominante semble donc être le bruit en 1/f de l'électronique de lecture, qui est externe au réseau de résonateurs.

La figure 2 illustre de manière schématique la variance d'Allan pour un résonateur NEMS individuel (courbe (a)) et pour un réseau de résonateurs NEMS tel que décrit dans [Bargatin2012] (courbe (b)).

Sur ce graphe, l'axe des abscisses représente le temps t d'intégration et l'axe des ordonnées la résolution de mesure en fréquence, définie par le rapport df/f.

La durée de 100 ms correspond à une limite entre le bruit blanc (pour lequel l'augmentation du temps d'intégration améliore la résolution) et le bruit en 1/f (pour lequel l'augmentation du temps d'intégration n'a pas d'effet sur la résolution) pour un résonateur individuel.

La comparaison des courbes (a) et (b) montre que la mise en réseau des résonateurs NEMS a un effet sur le bruit blanc des résonateurs, qui est décorrélé d'un résonateur à l'autre, puisqu'elle permet d'améliorer la résolution de mesure pour les faibles temps d'intégration.

En revanche, on n'observe pas d'effet réseau pour les temps d'intégration élevés qui correspondent au bruit en 1/f, qui est généré, comme mentionné ci-dessus, par l'électronique de lecture.

Un autre avantage des résonateurs mis en oeuvre dans l'invention est qu'ils peuvent être fabriqués sur un substrat semi-conducteur, par exemple de silicium, en mettant en oeuvre des techniques bien maîtrisées dans le domaine de la microélectronique, comprenant principalement de la photolithographie et de la gravure.

On s'affranchit ainsi du procédé de métallisation (du type « sputtering ») qui est mis en oeuvre pour la fabrication des jauges métalliques dans [Bargatin2012], qui est responsable de dispersions de fabrication.

On peut donc obtenir des dispersions de fabrication plus faibles, ce qui est un facteur d'obtention de l'effet réseau attendu.

Par ailleurs, le découplage de l'actionnement et de la détection permet de réduire de manière significative le signal de fond, au contraire des résonateurs métalliques décrits dans [Bargatin2012], dans lesquels la même résistance est utilisée pour actionner et détecter.

En effet, dans ces résonateurs métalliques, la variation de résistance électrique de la jauge métallique résulte d'une part de la déformation de la jauge (c'est-à-dire l'information recherchée) et de son auto-échauffement (qui constitue un signal parasite).

Ainsi, avec les résonateurs utilisés dans l'invention, la mesure n'est pas soumise à des fluctuations liées à l'actionnement de la poutre.

Agencement spatial des résonateurs du réseau

Une particularité d'un réseau mis en oeuvre dans un système selon l'invention est la densité des résonateurs appartenant audit réseau.

Plus précisément, une densité supérieure à 100 résonateurs / mm$^2$, de préférence supérieure à 1000 résonateurs / mm$^2$ est appropriée pour un tel réseau.

En effet, cette densité permet d'assurer que l'ensemble des résonateurs du réseau soient soumis simultanément au même environnement, et notamment au même échantillon de gaz à analyser.

De plus, elle permet de réduire les risques de dispersions de fabrication entre résonateurs, ces dispersions étant d'autant plus grandes que le réseau est spatialement étendu.

Par ailleurs, cette densité permet de former un réseau formé d'un grand nombre de résonateurs qui soit suffisamment compact pour pouvoir être introduit dans un canal fluidique dans laquelle circule l'échantillon de gaz à analyser, transporté par un gaz porteur.

A cet égard, on pourra noter que le réseau décrit dans [Bargatin2012] occupe une surface de 0,14 mm sur 1 mm, qui est difficilement compatible avec l'intégration dans un canal fluidique, dont la section est typiquement équivalente à celle d'un canal de section circulaire dont le diamètre est inférieur ou égal à 1 mm (un tel canal est généralement désigné par le terme « micro-fluidique »).

Enfin, une densité élevée de résonateurs permet de couvrir au mieux la surface du canal fluidique et par conséquent de rendre compte plus finement de la composition de l'échantillon à analyser.

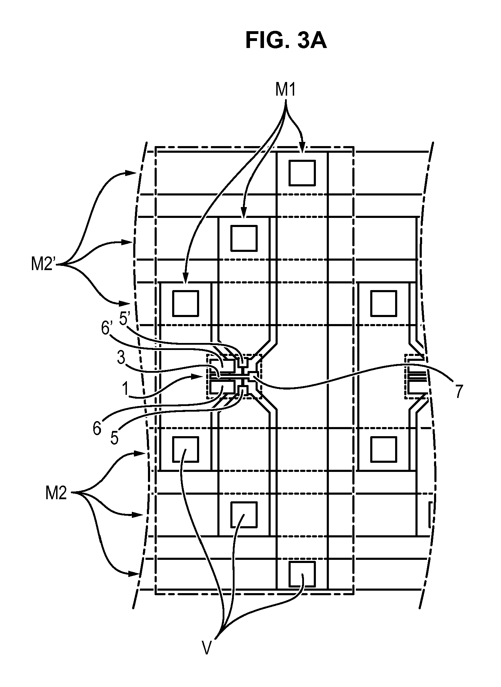

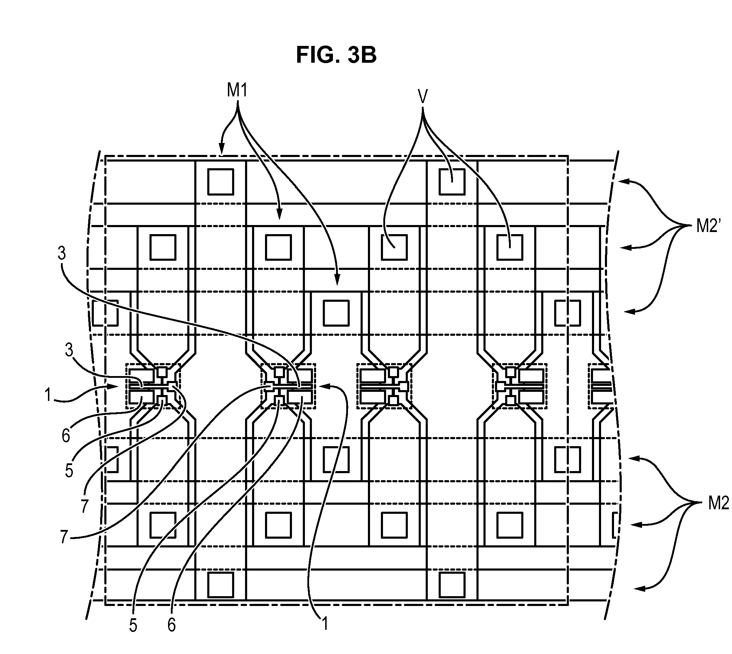

Les figures 3A et 3B illustrent deux modes d'agencement des résonateurs NEMS permettant d'obtenir la densité souhaitée.

La figure 3A illustre en vue de dessus une partie d'un réseau de résonateurs du type de celui illustré à la figure 1 selon un premier mode de réalisation.

Sur cette figure, seul un résonateur 1 a été représenté.

Le cadre en trait pointillé fort désigne une maille élémentaire du réseau, le réseau étant constitué d'une pluralité de telles mailles adjacentes agencées en lignes et/ou en colonnes.

Les deux niveaux de lignes d'interconnexion permettant la connexion électrique des résonateurs est également représentée.

Un premier niveau de lignes d'interconnexion métalliques parallèles est désigné par le repère M1 (lignes verticales sur la figure 3A).

Dans ce niveau, une première paire de lignes (la plus à gauche sur la maille élémentaire de la figure 3A) est connectée aux électrodes 6, 6' d'actionnement électrostatique ; une seconde paire de lignes (au centre de la maille élémentaire) est connectée aux électrodes 5, 5' d'application du potentiel aux jauges de contraintes ; enfin, une troisième ligne d'interconnexion (la plus à droite sur la maille élémentaire de la figure 3A) est connectée à l'électrode 7 de sortie du résonateur.

Un deuxième niveau de lignes d'interconnexion métalliques est désigné par les repères M2 et M2' (lignes horizontales sur la figure 3A).

Les lignes M2, M2' sont parallèles entre elles et perpendiculaires aux lignes d'interconnexion du premier niveau.

Les lignes M2, respectivement M'2, sont au nombre de trois et s'étendent de manière symétrique par rapport à l'axe longitudinal du résonateur.

Deux lignes (les plus proches du résonateur) sont destinées à la transmission du signal d'excitation des résonateurs ; deux lignes (les plus éloignées du résonateur) sont destinées à la transmission du signal de sortie des résonateurs ; enfin, deux lignes (intermédiaires entre les deux paires de lignes précitées) sont destinées à l'application de la tension de polarisation des électrodes des jauges de contrainte.

A cet effet, les lignes M2, M'2 sont connectées par des via d'interconnexion V aux lignes correspondantes du premier niveau d'interconnexion M1.

A titre purement indicatif, on peut obtenir avec cette configuration une dimension de maille élémentaire présentant une longueur (parallèle à la poutre) de 18 $\mu$m et une largeur de 41,2 $\mu$m, ou encore de 10,5 $\mu$m par 26,3 $\mu$m, voire de 7,5 $\mu$m par 20,3 $\mu$m.

Naturellement, l'organisation de ces niveaux d'interconnexion peut être modifiée par l'homme du métier sans pour autant sortir du cadre de l'invention.

Pour former le réseau, on connecte chaque résonateur en parallèle au deuxième niveau de lignes d'interconnexion M2, M'2, au moyen d'un premier niveau de lignes d'interconnexion du même type que les lignes M1 décrites ci-dessus.

La figure 3B illustre en vue de dessus une partie d'un réseau de résonateurs du type de celui illustré à la figure 1 selon un autre mode de réalisation.

Par rapport au réseau de la figure 3A, le réseau de la figure 3B est encore plus dense.

Les deux niveaux d'interconnexion décrits en référence à la figure 3A sont similaires et ne seront donc pas décrits à nouveau.

Dans ce réseau, les résonateurs sont agencés « tête-bêche », c'est-à-dire que, dans une ligne de résonateurs agencés en parallèle, chaque résonateur a deux voisins qui lui sont chacun symétriques par rapport à un plan perpendiculaire à l'axe longitudinal des poutres.

Ceci permet de mettre en commun à deux résonateurs les lignes du premier niveau d'interconnexion destinées à transmettre le signal d'excitation ainsi que la ligne de transmission du signal de sortie, d'où un gain en compacité du système.

A titre purement indicatif, on peut obtenir avec cette configuration une dimension de maille élémentaire (comprenant 4 résonateurs) présentant une longueur (parallèle à la poutre) de 44 $\mu$m et une largeur de 41,2 $\mu$m, ou encore de 28 $\mu$m par 26,3 $\mu$m, voire de 20 $\mu$m par 20,3 $\mu$m.

Sur ce principe, on peut donc organiser par exemple des matrices constituées de plusieurs lignes et colonnes de résonateurs agencés selon le motif de la figure 3A ou celui de la figure 3B.

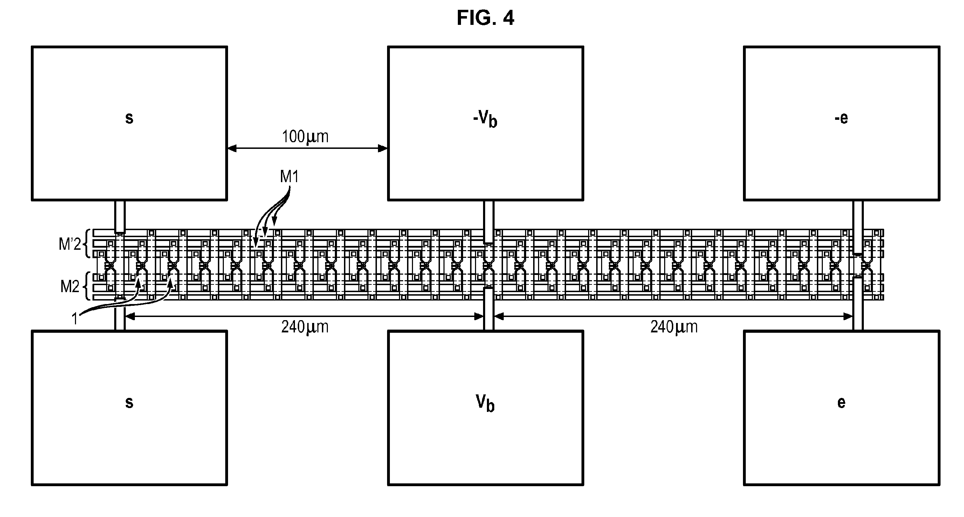

La figure 4 illustre en vue de dessus la connexion électrique d'un réseau de résonateurs selon l'agencement illustré à la figure 3A.

Les lignes M2, M2' du deuxième niveau d'interconnexion des résonateurs sont connectées à deux électrodes de sortie pour la transmission du signal s de sortie, deux électrodes d'application des tensions de polarisation Vb, -Vb aux jauges de contrainte et deux électrodes d'entrée pour l'application du signal d'excitation e, -e.

Organisation du réseau en groupes de résonateurs

Par ailleurs, et contrairement au réseau décrit dans [Bargatin2012], tous les résonateurs du réseau ne présentent pas la même fréquence de résonance à vide.

En effet, le réseau comprend au moins deux groupes d'au moins deux résonateurs, les résonateurs de chaque groupe présentant une fréquence de résonance à vide identique, différente de la fréquence de résonance à vide des résonateurs de chacun des autres groupes.

Dans la suite, on désignera par « fréquence de résonance à vide » d'un groupe la fréquence de résonance à vide de chacun des résonateurs formant ledit groupe, étant entendu qu'au sein d'un même groupe tous les résonateurs présentent une fréquence de résonance à vide identique.

Par « différente », on entend le fait que, dans une série de fréquences de résonance à vide croissantes, une fréquence de résonance à vide est supérieure d'au moins 1% à la fréquence de résonance à vide immédiatement inférieure.

Le terme « groupe » s'entend non seulement en termes de caractéristiques identiques des résonateurs (même fréquence de résonance à vide), mais aussi sur le plan spatial, les résonateurs d'un même groupe étant adjacents et par conséquent rassemblés sur une portion réduite de la surface totale du réseau.

La distance entre groupes de résonateurs peut être identique à la distance entre deux résonateurs d'un même groupe.

De manière alternative, deux groupes adjacents peuvent être séparés par une distance plus grande que la distance séparant deux résonateurs ; par exemple, selon les contraintes de fabrication, une certaine distance peut être ménagée entre des groupes adjacents que l'on souhaite fonctionnaliser différemment.

D'une manière générale, les dimensions du réseau sont limitées par la longueur de diffusion des particules de l'échantillon gazeux, qui est de l'ordre du millimètre.

Le nombre de résonateurs peut être identique pour tous les groupes ou varier d'un groupe à l'autre.

La connexion électrique des résonateurs du réseau est réalisée de la manière suivante.

D'une part, les résonateurs formant un même groupe sont connectés en parallèle, chaque groupe comprenant une entrée et une sortie connectées respectivement à l'entrée et à la sortie de chacun desdits résonateurs,

D'autre part, les groupes de résonateurs formant le réseau sont connectés en parallèle, ledit réseau comprenant une entrée et une sortie connectées respectivement à l'entrée et à la sortie de chacun desdits groupes de résonateurs.

Ainsi, le nombre d'entrées et de sorties du réseau est identique à celui d'un résonateur unitaire, ce qui ne complexifie pas l'architecture électrique.

Cette décomposition du réseau en groupes de résonateurs présente les avantages suivants.

D'une part, elle permet de limiter les effets des dispersions de fabrication.

En effet les dispersions d'un résonateur à l'autre sont d'autant plus grandes que les résonateurs sont distants l'un de l'autre.

Ainsi, même si le réseau est très compact grâce à un agencement optimal des résonateurs, deux résonateurs situés à deux extrémités opposées du réseau sont susceptibles de présenter des dispersions non négligeables.

Au contraire, au sein d'un même groupe, les dispersions entre résonateurs sont minimisées.

Par ailleurs, même s'il existe des dispersions entre des groupes de résonateurs distincts, il est possible de s'en affranchir par une correction mathématique, chaque groupe étant adressé indépendamment des autres.

Un autre avantage de cette décomposition du réseau en groupes est la possibilité de fonctionnaliser les résonateurs appartenant à des groupes différents avec des espèces chimiques différentes.

Ainsi, si les espèces chimiques de fonctionnalisation sont judicieusement choisies en fonction de l'échantillon de gaz à analyser, un même réseau est en mesure de fournir simultanément des informations sur plusieurs espèces contenues dans l'échantillon.

De manière avantageuse, l'obtention de fréquences de résonance à vide différentes entre groupes de résonateurs est due à la réalisation de résonateurs dont les poutres ont des longueurs différentes d'un groupe à l'autre, leurs autres caractéristiques mécaniques et géométriques étant par ailleurs identiques.

En effet, la fréquence de résonance à vide F* d'un résonateur est définie par la formule suivante :

$$F^* = \frac{1}{2\pi}\sqrt{\frac{EI}{\rho s}}\left(\frac{2,1178}{L}\right)^2$$

avec $I = \frac{w^3 e}{12}$ et s = w e,

où E est le module d'Young du matériau constituant le résonateur NEMS, p sa masse volumique, I le moment d'inertie du résonateur, s sa section, L et w respectivement la longueur et la largeur de la poutre vibrante, et e son épaisseur.

Le dimensionnement des résonateurs de chaque groupe est réalisé en déterminant, pour chaque groupe de résonateurs, un intervalle de variation maximale de fréquence de résonance attendue et en choisissant des longueurs de poutre (ou une autre caractéristique mécanique du résonateur) définissant des fréquences de résonance à vide suffisamment espacées les unes des autres pour que les intervalles de variation susmentionnés ne se chevauchent pas.

De préférence, des marges de sécurité sont prises en compte pour tenir compte d'éventuelles dispersions de fabrication.

Grâce à un tel dimensionnement des résonateurs de chacun des groupes, il est possible d'obtenir séparément et avec une bonne précision les informations des groupes de résonateurs du réseau.

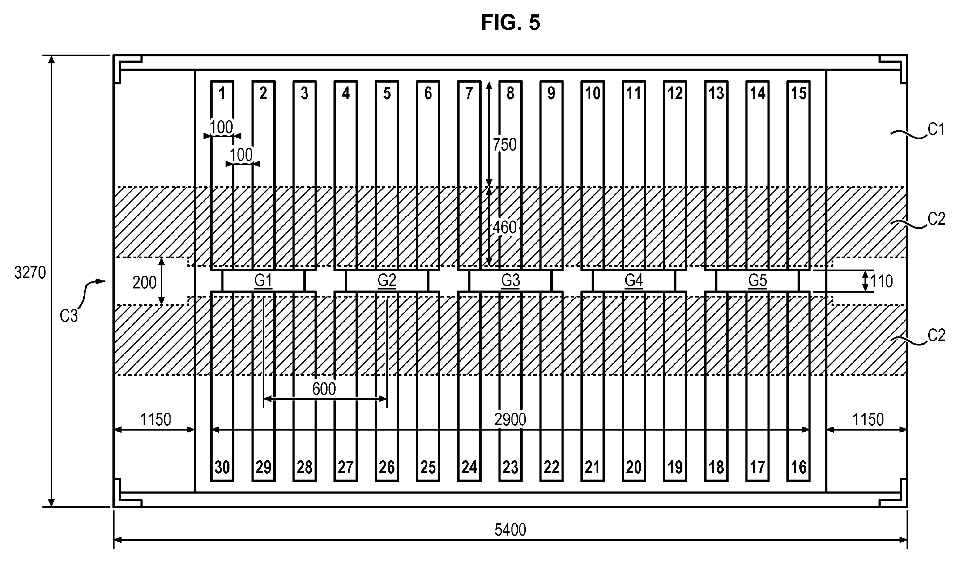

La figure 5 illustre en vue de dessus un exemple de mise en oeuvre d'un réseau tel que décrit ci-dessus dans un canal fluidique.

Ledit canal est gravé dans un support, par exemple de silicium, et collé sur le support des résonateurs NEMS, qui est ici une puce de silicium dopé, référencée C1.

Les surfaces hachurées C2 correspondent à l'interface de collage du support que l'on applique sur la puce C1 afin de former un canal fluidique sur la puce C1.

Le canal fluidique ainsi ménagé est repéré par la référence C3.

Les dimensions apparaissant sur cette figure sont exprimées en micromètres et visent simplement à fournir un exemple particulier d'implémentation d'un système de mesure, mais en aucun cas à limiter l'invention.

Dans cet exemple, le réseau comprend 5 groupes de résonateurs G1 à G5, chaque groupe présentant une fréquence de résonance à vide différente.

Les bandes verticales numérotées de 1 à 30 désignent les pistes de connexion à l'entrée, à la sortie et à la polarisation des jauges de contrainte de chacun des groupes de résonateurs.

Dans le cadre d'un système d'analyse de gaz, le canal fluidique dans lequel est agencé le réseau peut typiquement être agencé en aval d'une colonne de chromatographie.

Les moyens de liaison fluidique entre la colonne et un tel canal sont connus en eux-mêmes : il peut s'agir d'un capillaire de silice désactivée ou, si la colonne de chromatographie est elle-même gravée dans une puce de silicium, comme cela est décrit dans le document WO 2011/154362, le canal fluidique peut éventuellement être gravé dans la même puce.

De manière alternative, au moins un réseau tel que décrit plus haut peut être agencé à l'intérieur même d'une colonne de chromatographie gravée dans une puce de silicium.

De manière particulièrement avantageuse, on peut instrumenter ladite colonne en y installant une pluralité de réseaux distribués régulièrement entre l'entrée et la sortie de ladite colonne.

## Lecture du réseau

La lecture du réseau repose sur un adressage individuel des différents groupes de résonateurs, les résonateurs d'un même groupe étant adressés collectivement.

Cet adressage étant réalisé à partir des fréquences de résonance de chaque groupe de résonateurs, on peut le qualifier d'adressage fréquentiel.

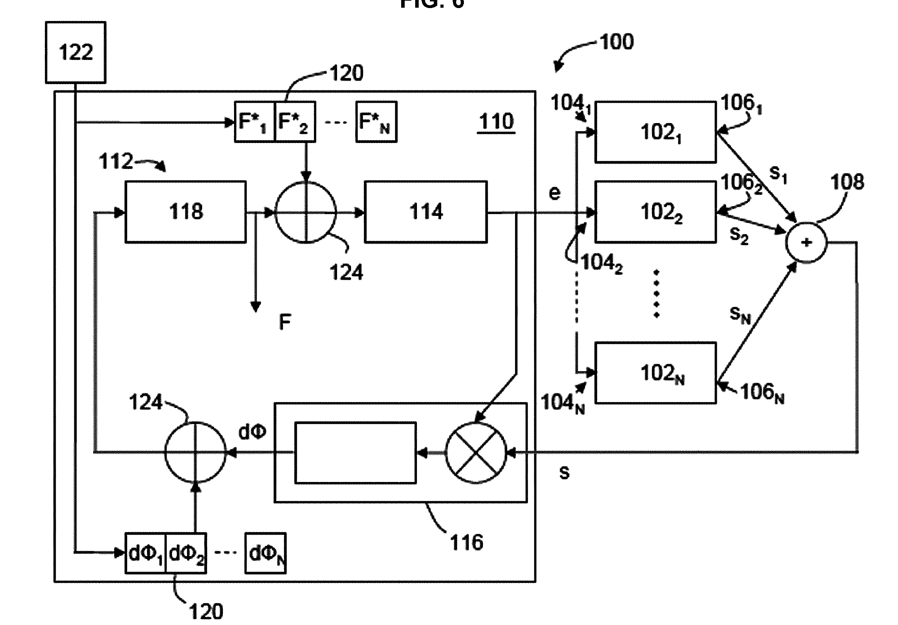

La figure 6 illustre de manière schématique l'architecture électrique du système.

Chaque groupe de résonateurs NEMS du réseau est désigné par le repère $102_i$, où i est un entier compris entre 1 et N, N étant le nombre de groupes formant le réseau.

Chacun de ces groupes est muni d'une entrée $104_i$ pour recevoir un signal d'excitation et une sortie $106_i$ pour fournir un signal de sortie.

Lorsque l'on applique à l'entrée 104i de chaque groupe de résonateurs un signal d'excitation e, comprenant une composante fréquentielle correspondant à la fréquence de résonance à vide (notée $F_i^*$) des résonateurs dudit groupe, les poutres des résonateurs sont entraînées en vibration, ce qui se traduit par la génération, par les jauges de contraintes associées à chaque poutre, d'un signal électrique de sortie qui correspond au signal d'excitation e, amplifié de manière importante autour de la fréquence de résonance $F_i$.

Les résonateurs d'un même groupe étant agencés en parallèle et collectivement adressés, le signal de sortie $s_i$ du groupe est une combinaison des signaux de chaque résonateur.

Le système comprend en outre un dispositif 108 de sommation des signaux de sortie $s_i$ en un signal total de sortie s.

Le système comprend par ailleurs un dispositif 110 de lecture des groupes de résonateurs 102i, qui est conçu pour fournir le signal d'excitation e à l'entrée du réseau, ledit signal d'excitation étant fourni à chaque groupe de résonateurs.

Le dispositif de lecture 110 est en outre conçu pour déterminer la fréquence de résonance d'un groupe de résonateurs sélectionné en injectant dans ledit signal d'excitation e une composante fréquentielle correspondant à la fréquence de résonance à vide mémorisée pour chaque groupe de résonateurs sélectionné et en identifiant, dans le signal total de sortie du réseau, une composante fréquentielle d'un groupe de résonateurs sélectionné.

Selon un mode de réalisation préféré, le dispositif de lecture comprend un circuit de boucle à phase asservie 112 (PLL, acronyme du terme anglo-saxon « Phase-Locked Loop »).

Ledit circuit 112 est avantageusement conçu pour caler une fréquence du signal d'excitation sur la fréquence d'un pic de résonance du signal de sortie du réseau et pour fournir, en tant que fréquence de résonance d'excitation, la fréquence calée.

A cet effet, le circuit de boucle à phase asservie 112 comprend un oscillateur contrôlé en tension 114 qui est contrôlé par une tension F et connecté aux entrées 104i des groupes 102i de résonateurs pour leur fournir le signal d'excitation e, ledit signal étant périodique et monofréquentiel, de fréquence correspondant à la fréquence de la tension F.

Le circuit 112 comporte en outre un comparateur de phase 116 connecté au dispositif de sommation 108 pour recevoir le signal total de sortie s et conçu pour déterminer et fournir un déphasage dΦ entre le signal total de sortie s et le signal d'excitation e.

Le circuit 112 comporte en outre un contrôleur 118 comparé au comparateur de phase 114 et conçu pour déterminer et fournir la tension F à l'oscillateur contrôlé en tension 114 à partir du déphasage dΦ.

Le dispositif de lecture 110 comporte en outre une mémoire 120 dans laquelle sont enregistrés, d'une part, les fréquences de résonance à vide F*i des groupes de résonateurs et, d'autre part, un déphasage initial dΦi pour chaque groupe 102i de résonateurs.

Par ailleurs, le dispositif de lecture 110 comprend des moyens de sélection de chacune des fréquences de résonance à vide F*i enregistrées et de chacun des déphasages initiaux dΦi enregistrés dans ladite mémoire 120.

Un avantage d'utiliser une boucle à phase asservie (PLL) par rapport à un autre dispositif, tel qu'un oscillateur ou une boucle ouverte comme proposé dans les articles cités plus haut est de mieux s'affranchir des dispersions.

En effet, bien que la boucle à phase asservie soit plus encombrante et plus complexe qu'un oscillateur qui ne nécessite que quelques transistors et met en oeuvre une conversion analogique-numérique aisée (compteurs), la boucle à phase asservie est plus robuste vis-à-vis des bruits et des dispersions. Elle permet en outre de sélectionner le mode de résonance et présente une bande passante ou un temps de réponse ajustables.

## Mesure différentielle

Un réseau tel que décrit ci-dessus présente l'avantage de présenter un bruit très faible.

Dans certaines situations, il pourra être avantageux de s'affranchir du bruit extrinsèque au réseau en mettant en oeuvre une mesure différentielle faisant appel à un résonateur ou réseau de résonateurs de référence, en faisant en sorte que le résonateur ou réseau de résonateurs de référence soit soumis au même environnement susceptible de générer des fluctuations, mais que ce résonateur ou réseau de résonateurs présente une réponse à l'échantillon de gaz qui soit différente de celle du réseau considéré.

En effet, une mesure différentielle permet d'éliminer l'influence de paramètres extérieurs - autres que l'adsorption du gaz par les résonateurs NEMS - responsables d'une modification de la fréquence de résonance des NEMS. On peut citer à titre d'exemple des fluctuations de température, des fluctuations du flux du gaz porteur, etc.

Le principe de cette méthode est expliqué ci-après sur la base d'un résonateur NEMS cible pour lequel on cherche à s'affranchir du bruit extrinsèque, et d'un résonateur NEMS de référence permettant de mettre en oeuvre la mesure différentielle, mais il va de soi qu'il s'applique également si l'on remplace le résonateur cible et/ou le résonateur de référence par un réseau comprenant un ou plusieurs groupes de résonateurs collectivement adressés.

L'efficacité de cette méthode de mesure repose essentiellement sur le fait que les deux résonateurs NEMS sont situés le plus près possible l'un de l'autre, de sorte à être soumis aux mêmes fluctuations, et que l'un des résonateurs NEMS ne soit pas (ou très peu) sensible au gaz à identifier.

Deux modes de réalisation permettent de remplir des conditions.

Selon un premier mode de réalisation, on met en place les NEMS dans deux canaux fluidiques distincts.

Ainsi, l'un des NEMS sera soumis au gaz porteur et à l'échantillon de gaz à analyser, tandis que l'autre (résonateur de référence) sera soumis uniquement au gaz porteur.

Selon un deuxième mode de réalisation, on met en place deux NEMS fonctionnalisés de manière différente dans le même canal fluidique.

En choisissant deux fonctionnalisations très différentes en termes d'adsorption du gaz à analyser, il est possible alors de réaliser une mesure différentielle. A cet effet, on fonctionnalise l'un des NEMS avec une espèce chimique sensible à l'échantillon de gaz à analyser, tandis que l'autre NEMS n'est pas fonctionnalisé par dépôt d'une couche spécifique (ledit résonateur peut, par exemple, être oxydé naturellement), ou est fonctionnalisé avec une espèce chimique non sensible au gaz à analyser. Par exemple, le résonateur NEMS cible peut être fonctionnalisé avec du SiOC et le résonateur de référence est simplement recouvert d'une couche d'oxyde natif.

Quelle que soit l'architecture de mesure retenue, la mesure électrique des deux résonateurs NEMS doit être réalisée individuellement afin de dissocier les fluctuations de la fréquence de résonance de l'un par rapport à l'autre.

Plusieurs approches de lecture électrique sont possibles :

- une mesure réalisée via 2 électroniques distinctes (lecture parallèle). Cependant, cette première approche n'est pas privilégiée car elle ne permet pas de s'affranchir des fluctuations associées à l'électronique de lecture ;
- une mesure réalisée via la même électronique en réalisant une mesure séquentielle dans le temps (chaque résonateur NEMS est lu alternativement sur une période de l'ordre de la ms afin d'assurer une lecture quasi-simultanée des 2 NEMS : la notion de quasi-simultanéité est définie en regard de la durée d'un pic de gaz et des fluctuations de la fréquence de résonance des NEMS ; en pratique, la durée de lecture de chaque résonateur NEMS est inférieure ou égale à 100 ms).

Cette seconde approche permet de s'affranchir des fluctuations de l'électronique de lecture en plus des fluctuations environnementales pouvant affecter la fréquence de résonance des résonateurs NEMS.

La mise en oeuvre pratique de cette mesure peut être réalisée selon un adressage fréquentiel (deux résonateurs NEMS avec deux fréquences de résonance à vide différentes reliés en parallèle) ou bien avec l'utilisation d'un commutateur pour commuter d'un résonateur NEMS à l'autre dans le temps.

Une fois la mesure simultanée (ou quasi simultanée à l'échelle de la durée des pics de gaz) des deux résonateurs NEMS réalisée, le travail de traitement du signal consiste principalement à soustraire la réponse du résonateur NEMS de référence de la réponse du résonateur NEMS cible pour éliminer ainsi toutes les fluctuations de la fréquence de résonance induites par des paramètres extérieurs autres que l'échantillon de gaz s'adsorbant sur les résonateurs NEMS.

Dans le cadre du système de mesure selon l'invention, le résonateur ou groupe de résonateurs de référence peut faire partie du réseau lui-même, et ne pas comporter de fonctionnalisation spécifique de manière à être notablement moins sensible que les autres groupes de résonateur à l'échantillon gazeux à analyser.

Comme mentionné plus haut, ce principe de mesure différentielle n'est pas limité à un réseau de NEMS mais peut être mis en oeuvre de manière générale pour s'affranchir des fluctuations extérieures à un résonateur NEMS, qu'il fasse partie ou non d'un réseau.

La comparaison des signaux dudit résonateur et d'un résonateur de référence permet d'améliorer le rapport signal sur bruit dudit résonateur.

Fonctionnement du système

Au cours d'une opération de calibration, les fréquences de résonance à vide $F^*i$ et les déphasages initiaux $d\Phi i$ sont déterminés par exemple en balayant en boucle ouverte l'espace des fréquences avec l'oscillateur contrôlé en tension 114.

Ces données sont enregistrées dans la mémoire 120.

En fonctionnement, on fait circuler dans le canal fluidique dans lequel est agencé le réseau de résonateurs l'échantillon gazeux à analyser, qui est transporté par un gaz porteur.

En général, le gaz porteur et l'échantillon proviennent d'une colonne de chromatographie agencée en amont.

Au cours d'une opération de lecture d'un groupe de résonateurs 102i, les moyens de sélection 122 sélectionnent la fréquence de résonance à vide F*i et le déphasage dΦi dudit groupe de résonateurs dont la lecture est souhaitée.

Les moyens de démarrage injectent alors ces valeurs dans la boucle à phase asservie 112, de manière à assurer l'accrochage de ladite boucle 112 à la fréquence de résonance du groupe de résonateurs 102i.

Ainsi, au terme d'un temps de calage qui est généralement de l'ordre de 50 μs, la fréquence calée F correspond à la fréquence de résonance du groupe de résonateurs 102i.

L'opération de lecture est répétée successivement pour tous les groupes de résonateurs formant le système.

Par la suite, la grandeur physique dont la mesure est recherchée par la mesure du groupe de résonateurs (par exemple, la masse d'une espèce de l'échantillon gazeux adsorbée sur les poutres des résonateurs dudit groupe) est déterminée à partir de la fréquence de résonance lue et de la fréquence de résonance à vide dudit groupe de résonateurs, par exemple à partir de la différence entre la fréquence de résonance et la fréquence de résonance à vide.

Cette détermination est à la portée de l'homme du métier spécialiste de l'analyse gravimétrique de gaz et ne sera donc pas détaillée ici.

On notera que d'autres modes de réalisation du dispositif de lecture pourront être mis en oeuvre sans pour autant sortir du cadre de l'invention. On pourra à cet égard se référer à la demande PCT/FR2012/050682 déposée le 29 mars 2012.

Traitement des signaux

Une fois lus les signaux de sortie de chaque groupe de résonateurs (notés $x_i(t)$), on les fusionne de façon à obtenir un signal X(t) présentant des caractéristiques améliorées.

Le système de mesure comporte à cet effet un système de traitement permettant d'implémenter un algorithme de fusion.

Différents algorithmes permettent d'effectuer une telle fusion de données et sont à la portée de l'homme du métier selon les caractéristiques des signaux individuels.

D'une manière générale, la fusion de données consiste à combiner des signaux, de préférence à les comparer, par exemple par soustraction ou par division.

Par exemple, dans le cas où les bruits de chaque groupe sont totalement indépendants (décorrélés) les uns des autres, la fusion peut consister à effectuer une moyenne spatiale desdits signaux après les avoir normalisés, selon la formule :

$$\bar{X}(t) = \frac{1}{N} \sum_{i=1}^{N} \frac{xi(t) - <xi(t)>}{<xi(t)>} \qquad \text{(f1)}$$

l'opérateur $<x_i(t)>$ désignant une moyenne temporelle du signal $x_i$, par exemple sur la durée de l'expérience.

Lorsque les bruits sont corrélés, une stratégie de fusion possible peut être basée sur la mesure différentielle décrite plus haut, selon la formule suivante :

$$X(t) = \frac{1}{N} \sum_{i=1}^{N} \frac{xi(t) - <xi(t)>}{<xi(t)>} - \frac{xref(t) - <xref(t)>}{<xref(t)>} \qquad \text{(f2)}$$

où $x_{ref}(t)$ est le signal de sortie d'un résonateur (ou d'un réseau de résonateurs, éventuellement constitué de différents groupes de résonateurs) de référence, qui n'est pas agencé dans le même canal fluidique ou qui est agencé dans le même canal mais qui présente une réponse à l'échantillon gazeux indépendante de celle du réseau utilisé pour la mesure.

Naturellement, l'homme du métier pourra mettre en oeuvre tout autre algorithme sans pour autant sortir du cadre de la présente invention.

Validations expérimentales du système

Les inventeurs ont validé expérimentalement les performances du système décrit plus haut.

Dans une première approche, pour valider la technique de lecture, les réseaux testés étaient composés d'une pluralité de résonateurs présentant chacun une fréquence de résonance à vide différente (en d'autres termes, chaque groupe de résonateurs était constitué d'un unique résonateur).

Pour mettre en évidence la possibilité de s'affranchir des fluctuations externes au réseau, une première expérience a consisté à réaliser un réseau de 4 résonateurs présentant des fréquences de résonance différentes.

Lesdits résonateurs étaient connectés en parallèle et reliés au même dispositif de lecture, qui était conçu pour lire les signaux de chaque résonateur par la technique d'adressage fréquentiel décrite plus haut. L'architecture électrique était celle représentée à la figure 6.

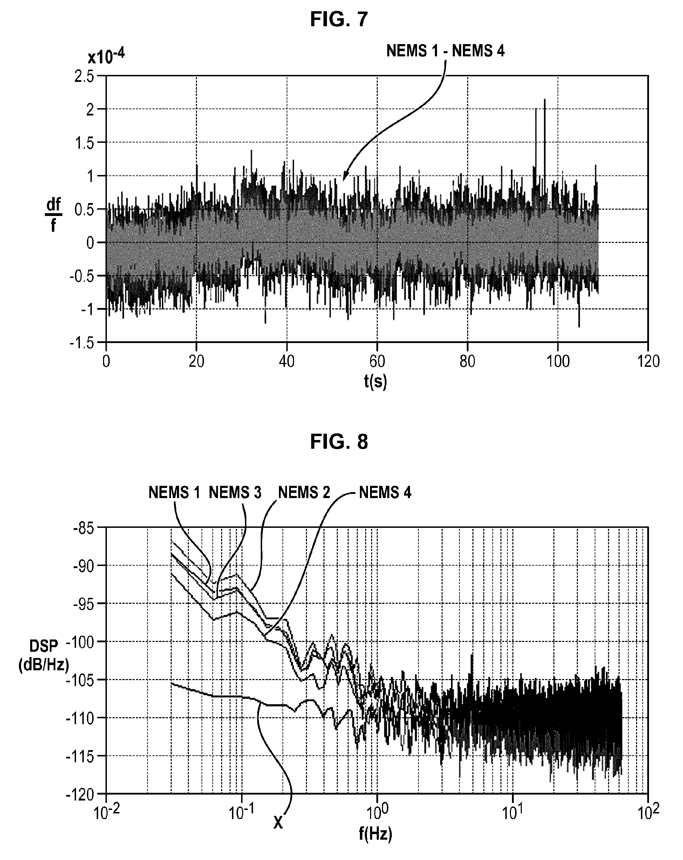

La figure 7 présente le signal (df/f) en fonction du temps pour chacun des quatre résonateurs NEMS1 à NEMS4, la mesure étant effectuée dans l'air, à pression atmosphérique.

On observe dans ce cas une forte corrélation des signaux issus des différents résonateurs.

Dans ce cas, la source de bruit prépondérante est le bruit en 1 /f du dispositif de lecture.

Il est cependant possible de s'affranchir de ce bruit en appliquant l'algorithme de fusion défini par la formule (f2) à la moyenne des signaux des résonateurs NEMS1 à NEMS4, le résonateur de référence étant ici le résonateur NEMS1.

On peut constater que le signal reconstruit grâce à cette fusion présente une forte atténuation du bruit en 1/f.

La figure 8 présente ainsi la densité spectrale de fréquence (DSP, exprimée en dB/Hz) pour les signaux issus de chacun des résonateurs NEMS1 à NEMS4 et pour le signal reconstruit X.

On observe un gain de l'ordre de 20 dB sur la densité spectrale de puissance sur la bande comprise entre 0 et 0,1 Hz.

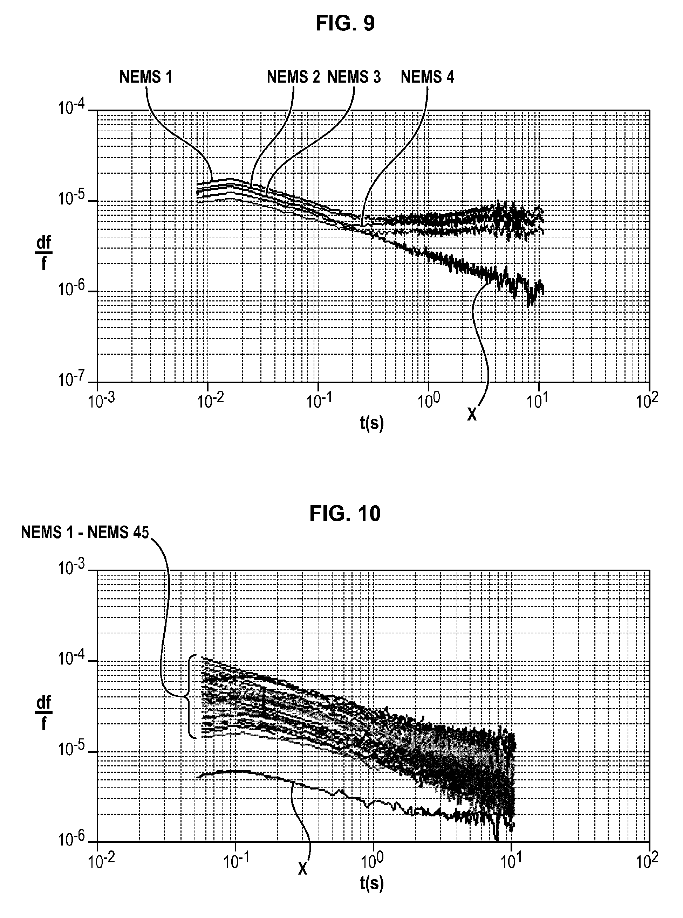

Cette amélioration peut également être constatée sur la variance d'Allan qui est illustrée à la figure 9. Il existe en effet une bijection entre la densité spectrale de fréquence et la variance d'Allan.

On observe ainsi une diminution de la variance d'Allan selon une pente constante dans une bande de période d'intégration qui correspond au bruit en 1/f, et pour laquelle la variance d'Allan de chacun des résonateurs stagne.

Ainsi, dans le cas où la source de bruit prédominante est externe aux résonateurs (ce qui est typiquement le cas de l'électronique de lecture), la mise en réseau des résonateurs permet d'éliminer ce bruit en mettant en oeuvre une technique de fusion telle que décrite ci-dessus.

Une deuxième expérience a été conduite pour mettre en évidence la capacité du système à réduire les sources de bruit intrinsèques aux résonateurs.

Dans cette expérience, un réseau de 45 résonateurs a été réalisé et mesuré dans l'air, à pression atmosphérique.

Le signal équivalent aux 45 signaux a été reconstruit par l'algorithme de fusion selon la formule (f1).

La figure 10 présente la variance d'Allan pour chacun des 45 résonateurs NEMS1 à NEMS45 et pour le signal X reconstruit.

On observe une amélioration de la variance d'Allan par un facteur d'environ $\sqrt{45} = 6{,}7$ sur le bruit blanc, ce qui montre que l'effet réseau a été obtenu.

Une expérience similaire a été réalisée sous vide, avec un réseau de 16 résonateurs.

Le signal équivalant aux 16 réseaux a été reconstruit par l'algorithme de fusion selon la formule (f1).

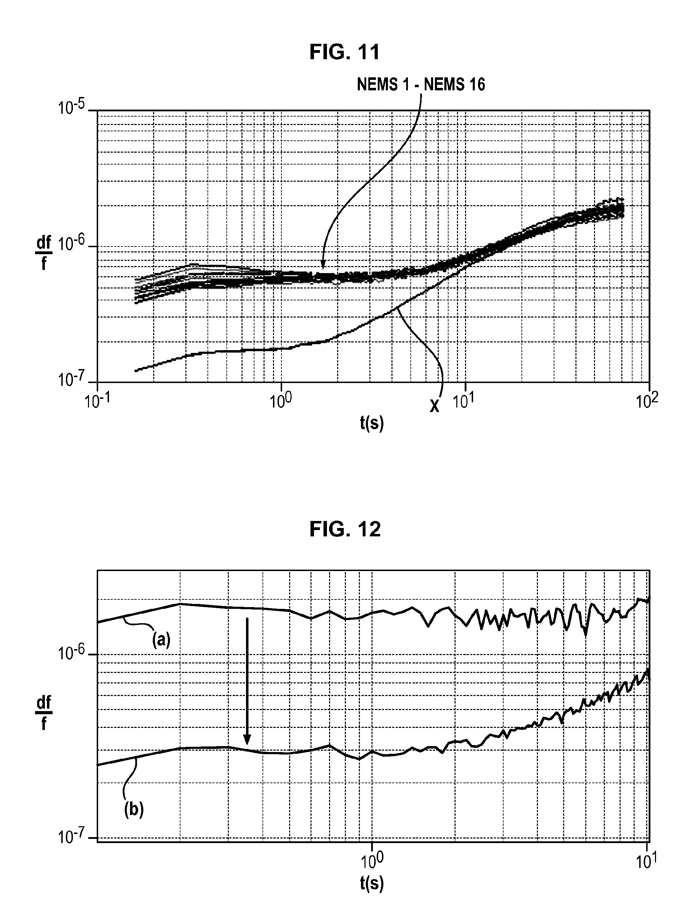

La figure 11 présente la variance d'Allan pour chacun des 16 résonateurs NEMS1 à NEMS16 et pour le signal X reconstruit.

On observe une amélioration de la variance d'Allan par un facteur d'environ $\sqrt{16} = 4$ sur le bruit blanc, ce qui montre que l'effet réseau a été obtenu.

Dans ce cas, la source de bruit en 1/f est intrinsèque aux résonateurs.

A long terme, on observe une dérive de la variance d'Allan qui est due à une corrélation entre les bruits des résonateurs. Il est cependant possible de s'affranchir de cette dérive en effectuant une mesure différentielle telle que décrite plus haut.

Une autre expérience a été réalisée avec un réseau constitué d'un groupe de 75 résonateurs présentant tous la même fréquence de résonance à vide.

La figure 12 illustre la variance d'Allan pour un résonateur unitaire (courbe (a)) et pour ledit groupe de résonateurs (courbe (b)), dans la plage de temps d'intégration correspondant au bruit en 1/f.

On observe une réduction d'un facteur environ égal à 6 pour le groupe de résonateurs, ce qui est relativement proche de l'effet réseau attendu $(\sqrt{75} = 8{,}66)$. 8,66).

Enfin, une expérience permettant de mettre en évidence l'amélioration de la limite de détection dans le cas du groupe de 75 résonateurs mentionné ci-dessus par rapport à un résonateur unitaire a été réalisée en injectant séquentiellement trois échantillons de toluène sur le groupe de résonateurs et sur le résonateur unitaire.

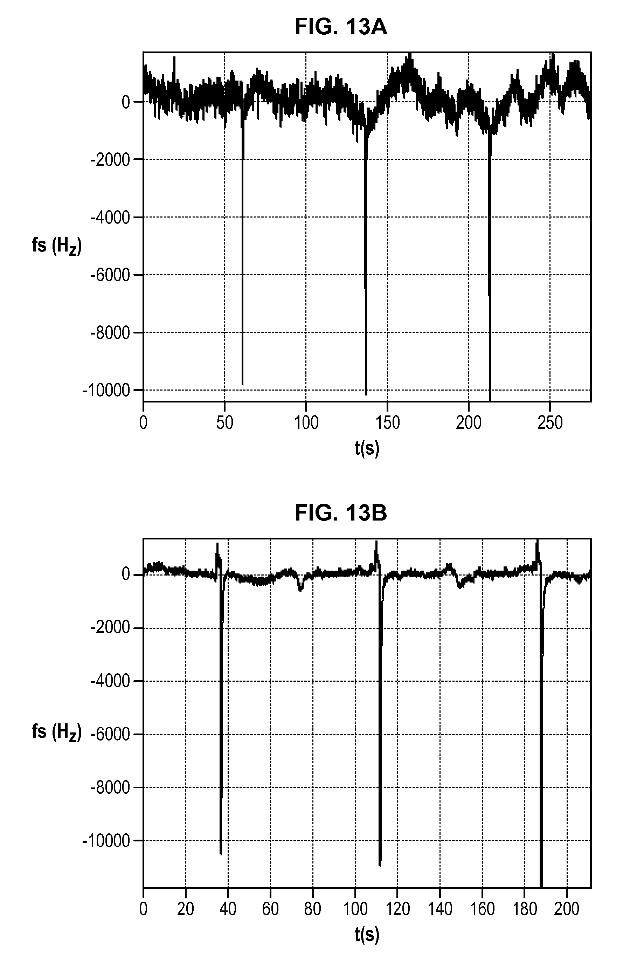

La figure 13A illustre le déplacement de fréquence fs (« frequency shift » selon la terminologie anglo-saxonne) pour le résonateur unitaire. On observe un bruit important sur le signal enregistré.

La figure 13B illustre le déplacement de fréquence pour le groupe de 75 résonateurs. On peut observer que le bruit est sensiblement plus faible que dans le premier cas.

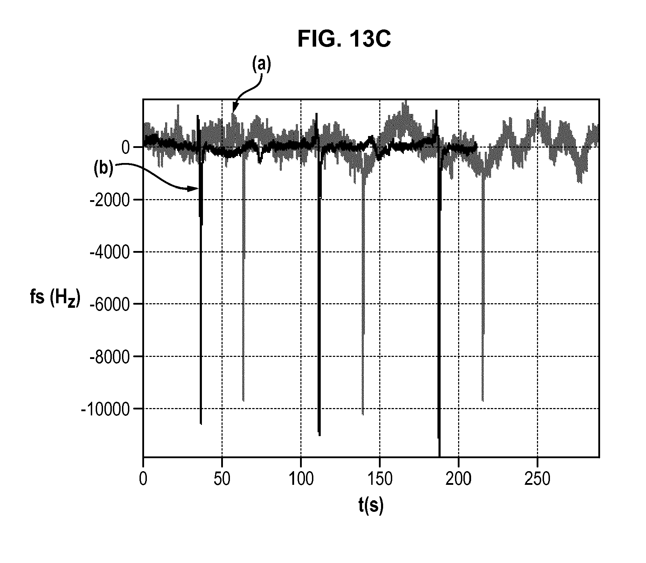

Enfin, la figure 13C présente la superposition des courbes des figures 13A (courbe (a) et 13B (courbe (b)), qui montre que le bruit est sensiblement diminué avec le groupe de résonateurs, de sorte que la limite de détection est améliorée significativement.

Procédé de fabrication du réseau

Du fait de la mise en oeuvre d'une détection piézorésistive au moyen de jauges de contrainte en matériau semi-conducteur dopé, il est possible de réaliser chaque résonateur sur un substrat dudit matériau semi-conducteur par des techniques de la microélectronique, comprenant de la photolithographie et de la gravure.

De manière avantageuse, ledit matériau semi-conducteur est du silicium.

Pour connecter les résonateurs en réseau, deux niveaux d'interconnexion sont réalisés par métallisation, et des via d'interconnexion sont formées pour connecter ces deux niveaux.

De manière particulièrement avantageuse, les résonateurs du réseau sont fabriqués collectivement sur une partie d'un substrat, qui peut ensuite être individualisée pour former une puce portant ledit réseau.

On peut ainsi réaliser, à partir d'un substrat de silicium de 200 ou 300 mm de diamètre, fabriquer une pluralité de puces supportant chacune un ou plusieurs réseaux.

Une telle puce présente des dimensions micrométriques qui permettent son agencement dans une veine fluidique d'un système d'analyse de gaz.

Par ailleurs, les différents groupes de résonateurs peuvent être fonctionnalisés par une même espèce chimique, dont l'uniformité est assurée par des techniques de dépôt physique ou chimique en phase vapeur (PVD ou CVD).

De manière alternative, les différents groupes de résonateur constituant le réseau peuvent être fonctionnalisés avec des espèces chimiques différentes, selon les espèces contenues dans l'échantillon de gaz à analyser.

On effectue alors un dépôt PVD ou CVD de manière sélective sur le(s) groupe(s) à fonctionnaliser, par exemple par une technique dite de « lift-off » ou par un masquage par pochoir.

Comme mentionné plus haut, un avantage de cette conception des résonateurs est qu'elle permet de diminuer les dispersions de fabrication.

On estime ainsi que l'on peut atteindre des dispersions inférieures à 0,1% sur la fréquence de résonance des résonateurs appartenant à un même groupe au sein du réseau.

Ces dispersions peuvent donc être considérées comme négligeables dans le fonctionnement du réseau.

**REFERENCES**

[Bargatin2012] I. Bargatin, E.B. Myers, J.S. Aldridge, C. Marcoux, P. Brianceau, L. Duraffourg, E. Colinet, S. Hentz, P. Andreucci, M.L. Roukes, Large-Scale Integration of Nanoelectromechanical Systems for Gas Sensing Applications, NanoLetters 12, 1269-1274 (2012)

[Mile2010] E. Mile, G. Jourdan, I. Bargatin, S. Labarthe, C. Marcoux, P. Andreucci, S. Hentz, C. Kharrat, E. Colinet, L. Duraffourg, In-plane nanoelectromechanical resonators based on silicon nanowire piézorésistives détection, Nanotechnology 21, (2010) 165504

WO 2011/154363

EP 2 008 965

WO 2012/034990

WO 2012/034951

WO 2011/154362

**Revendications**

**1.** Système de mesure comprenant un réseau de résonateurs de type nano-système électromécanique (NEMS), **caractérisé en ce que** :

   • chacun desdits résonateurs comprend :

      - une entrée pour recevoir un signal d'excitation et une sortie pour fournir un signal de sortie en réponse audit signal d'excitation, ledit signal de sortie présentant une résonance à la fréquence de résonance du résonateur,
      - une poutre suspendue par rapport à un support, la fréquence de résonance à vide du résonateur correspondant à la fréquence de résonance à vide de ladite poutre,

- un dispositif d'actionnement électrostatique apte à générer une vibration de ladite poutre sous l'effet dudit signal d'excitation,

- au moins une jauge de contrainte piézorésistive en matériau semi-conducteur dopé, suspendue par rapport audit support et s'étendant à partir de la poutre de sorte à détecter un déplacement de ladite poutre, la variation de résistance électrique de ladite au moins une jauge fournissant ledit signal de sortie,

• ledit réseau comprend au moins deux groupes de résonateurs, chaque groupe comprenant au moins deux résonateurs présentant une fréquence de résonance à vide identique, chaque groupe de résonateurs présentant une fréquence de résonance à vide différente de celle de chaque autre groupe,

• le système comprend une mémoire dans laquelle est enregistrée une information relative à la fréquence de résonance à vide de chaque résonateur ou groupe de résonateurs,

• les résonateurs formant chaque groupe sont connectés en parallèle, chaque groupe comprenant une entrée et une sortie connectées respectivement à l'entrée et à la sortie de chacun desdits résonateurs,

• les groupes de résonateurs formant ledit réseau sont connectés en parallèle, ledit réseau comprenant une entrée et une sortie connectées respectivement à l'entrée et à la sortie de chacun desdits groupes de résonateurs,

• ledit système comprend un dispositif de lecture conçu pour fournir un signal d'excitation à l'entrée du réseau et pour déterminer la fréquence de résonance d'un groupe de résonateurs sélectionné en injectant dans ledit signal d'excitation une composante fréquentielle correspondant à la fréquence de résonance à vide mémorisée pour chaque groupe de résonateurs sélectionné et en identifiant, dans le signal de sortie du réseau, une composante fréquentielle de résonance du groupe de résonateurs sélectionné.

**2.** Système selon la revendication 1, **caractérisé en ce qu'**il comprend un dispositif de sommation des signaux de sortie de chaque groupe de résonateurs du réseau en un signal total de sortie du réseau et **en ce que** le dispositif de lecture est conçu pour déterminer la fréquence de résonance d'un groupe de résonateurs à partir dudit signal total de sortie du réseau.

**3.** Système selon la revendication 2, **caractérisé en ce que** ledit dispositif de lecture comprend un circuit à boucle de phase asservie (PLL) conçu pour caler une fréquence du signal d'excitation sur la fréquence d'un pic de résonance du signal de sortie du réseau et pour fournir, en tant que fréquence de résonance d'excitation, la fréquence calée.

**4.** Système selon l'une des revendications 1 à 3, **caractérisé en ce que** chaque groupe de résonateurs est fonctionnalisé avec une espèce chimique différente.

**5.** Système selon l'une des revendications 1 à 4, **caractérisé en ce que** les résonateurs du réseau sont agencés sur un même support de sorte à former des lignes et des colonnes de résonateurs s'étendant parallèlement les uns aux autres, les poutres des résonateurs étant parallèles les unes aux autres.

**6.** Système selon l'une des revendications 1 à 4, **caractérisé en ce que** les résonateurs du réseau sont agencés sur un même support de sorte à former des lignes et des colonnes de résonateurs s'étendant parallèlement les uns aux autres, lesdits résonateurs étant en outre agencés de sorte que, sur une même ligne parallèle aux poutres des résonateurs, deux résonateurs adjacents soient symétriques par rapport à un plan parallèle à une colonne.

**7.** Système selon l'une des revendications 1 à 6, **caractérisé en ce qu'**il comprend au moins un canal fluidique destiné à l'écoulement d'un échantillon gazeux à analyser, ledit réseau de résonateurs étant agencé dans ledit canal fluidique de sorte que les poutres desdits résonateurs soient exposées audit échantillon.

**8.** Système selon la revendication 7, **caractérisé en ce qu'**il comprend au moins deux réseaux de résonateurs dans ledit canal fluidique.

**9.** Système selon l'une des revendications 7 ou 8, **caractérisé en ce qu'**il comprend au moins un résonateur dit de référence agencé hors du canal fluidique et connecté au même dispositif de lecture que le réseau agencé dans le canal fluidique, et **en ce qu'**il comprend un système de traitement configuré pour combiner le signal de sortie dudit résonateur de référence avec les signaux de sortie des groupes de résonateurs du réseau.

**10.** Système selon l'une des revendications 7 ou 8, **caractérisé en ce que** le réseau comprend au moins un résonateur dit de référence configuré pour être moins sensible à l'échantillon gazeux que les autres groupes de résonateurs et **en ce que** le système comprend un système de traitement configuré pour combiner le signal de sortie dudit résonateur de référence avec les signaux de sortie des groupes de résonateurs du réseau.

11. Système selon l'une des revendications 1 à 8, **caractérisé en ce qu'**il comprend un système de traitement configuré pour combiner les signaux de sortie de chaque groupe de résonateurs du réseau avec une moyenne desdits signaux

12. Système selon l'une des revendications 7 à 11, **caractérisé en ce qu'**il comprend une colonne de chromatographie en phase gazeuse contenant ledit canal fluidique.

13. Système selon la revendication 12, **caractérisé en ce que** le canal de ladite colonne de chromatographie comprend une pluralité de réseaux de résonateurs distribués régulièrement entre l'entrée et la sortie de ladite colonne.

14. Système selon l'une des revendications 7 à 11, **caractérisé en ce qu'**il comprend une colonne de chromatographie en phase gazeuse en amont dudit canal fluidique dans la direction d'écoulement de l'échantillon gazeux.

15. Procédé de lecture d'un système selon l'une des revendications 1 à 14, **caractérisé en ce qu'**il comprend les étapes consistant à :

   • sélectionner, parmi les groupes de résonateurs du réseau, un groupe de résonateurs à lire,
   • récupérer dans la mémoire l'information de résonance à vide de chaque groupe de résonateurs sélectionné,
   • appliquer un signal d'excitation au réseau comprenant une composante fréquentielle correspondant à la fréquence de résonance à vide de chaque groupe de résonateurs sélectionné,
   • déterminer la fréquence de résonance de chaque groupe de résonateurs sélectionné en identifiant, dans le signal de sortie du réseau, une composante fréquentielle de résonance de chaque groupe de résonateurs sélectionné.

16. Procédé selon la revendication 15, **caractérisé en ce que** l'application dudit signal d'excitation génère dans le signal de sortie une composante fréquentielle principale correspondant à la résonance de chaque groupe de résonateurs sélectionné, et **en ce que** l'on détermine la fréquence de résonance de chaque groupe de résonateurs sélectionné en extrayant ladite composante fréquentielle du signal de sortie du réseau.

17. Procédé de fabrication d'un système selon l'une des revendications 1 à 14, **caractérisé en ce qu'**il comprend la fabrication collective, sur un support en un matériau semi-conducteur, des résonateurs formant ledit réseau en mettant en oeuvre des techniques de microélectronique.

18. Procédé selon la revendication 17, **caractérisé en ce qu'**il comprend la fonctionnalisation collective des groupes de résonateurs dudit réseau par dépôt chimique en phase vapeur (CVD) ou dépôt physique en phase vapeur (PVD) d'espèces chimiques différentes pour chacun desdits groupes.

**Patentansprüche**

1. Messsystem umfassend ein Netzwerk aus Resonatoren des Typs nanoelektromechanisches System (NEMS), **dadurch gekennzeichnet, dass**:

   • jeder der Resonatoren folgendes umfasst:

      - einen Eingang zum Empfang eines Erregersignals und einen Ausgang zum Liefern eines Ausgangssignals als Antwort auf das Erregersignal, wobei das Ausgangssignal eine Resonanz mit der Frequenz der Resonanz des Resonators aufweist,
      - ein im Verhältnis zu einem Träger hängender Balken, wobei die Vakuumresonanzfrequenz des Resonators der Frequenz der Vakuumresonanz des Balkens entspricht,
      - eine Vorrichtung zur elektrostatischen Betätigung, die fähig ist, eine Schwingung des Balkens unter der Wirkung des Erregersignals zu generieren,
      - zumindest einen piezoresistiven Dehnungsmesser aus dotiertem Halbleitermaterial, der im Verhältnis zum Träger hängt und sich derart ab dem Balken erstreckt, dass er eine Verschiebung des Balkens erkennt, wobei die Variation des elektrischen Widerstands des zumindest einen Dehnungsmessers das Ausgangssignal liefert,

• das Netzwerk zumindest zwei Resonatorgruppen umfasst, wobei jede Gruppe zumindest zwei Resonatoren mit identischer Vakuumresonanzfrequenz umfasst, wobei jede Resonatorgruppe eine Vakuumresonanzfrequenz aufweist, die sich von derjenigen jeder anderen Gruppe unterscheidet,

• das System einen Speicher umfasst, in dem eine Information in Bezug auf die Frequenz der Vakuumresonanz von jedem Resonator oder jeder Resonatorgruppe gespeichert ist,

• die jede Gruppe bildenden Resonatoren parallel angeschlossen sind, wobei jede Gruppe einen Eingang und einen Ausgang umfasst, die jeweils am Eingang und am Ausgang von jedem der Resonatoren angeschlossen sind,

• die das Netzwerk bildenden Resonatorgruppen parallel angeschlossen sind, wobei das Netzwerk einen Eingang und einen Ausgang umfasst, die jeweils an den Eingang und den Ausgang von jeder der Resonatorgruppen angeschlossen sind,

• das System eine Lesevorrichtung umfasst, die ausgelegt ist, um ein Erregersignal am Eingang des Netzwerks zu liefern und die Resonanzfrequenz einer ausgewählten Resonatorgruppe zu bestimmen, indem dem Erregersignal eine Frequenzkomponente eingegeben wird, die der Frequenz der Vakuumresonanz, die für jede ausgewählte Resonatorgruppe gespeichert ist, entspricht, und indem im Ausgangssignal des Netzwerks eine Frequenzkomponente der Resonanz der ausgewählten Resonatorgruppe identifiziert wird.

2. System nach Anspruch 1, **dadurch gekennzeichnet, dass** es eine Vorrichtung zur Summierung der Ausgangssignale von jeder Resonatorgruppe des Netzwerks in ein Gesamtsignal des Netzwerkausgangs umfasst, und dadurch, dass die Lesevorrichtung dazu ausgelegt ist, die Resonanzfrequenz einer Resonatorgruppe anhand des Gesamtsignals des Netzwerkausgangs zu bestimmen.

3. System nach Anspruch 2, **dadurch gekennzeichnet, dass** die Lesevorrichtung eine Phasenregelschleifen-Schaltung (PLL) umfasst, die ausgelegt ist, um eine Frequenz des Erregersignals auf die Frequenz einer Resonanzspitze des Ausgangssignals des Netzwerks einzustellen und die eingestellte Frequenz als Resonanzfrequenz zu liefern.

4. System nach einem der Ansprüche 1 bis 3, **dadurch gekennzeichnet, dass** jede Resonatorgruppe mit einer anderen chemischen Spezies funktionalisiert ist.

5. System nach einem der Ansprüche 1 bis 4, **dadurch gekennzeichnet, dass** die Resonatoren des Netzwerkes derart auf demselben Träger angeordnet sind, dass sie Reihen und Säulen aus Resonatoren bilden, die sich parallel zueinander erstrecken, wobei die Balken der Resonatoren parallel zueinander verlaufen.

6. System nach einem der Ansprüche 1 bis 4, **dadurch gekennzeichnet, dass** die Resonatoren des Netzwerkes derart auf demselben Träger angeordnet sind, dass sie Reihen und Säulen aus Resonatoren bilden, die sich parallel zueinander erstrecken, wobei die Resonatoren des Weiteren derart angeordnet sind, dass auf derselben zu den Balken der Resonatoren parallelen Reihe, zwei benachbarte Resonatoren symmetrisch im Verhältnis zu einer Ebene, die parallel zu einer Säule ist, sind.

7. System nach einem der Ansprüche 1 bis 6, **dadurch gekennzeichnet, dass** es zumindest einen Fluidikkanal umfasst, der zum Ausströmen einer zu analysierenden Gasprobe vorgesehen ist, wobei das Netzwerk aus Resonatoren derart im Fluidikkanal angeordnet ist, dass die Balken der Resonatoren der Probe ausgesetzt sind.

8. System nach Anspruch 7, **dadurch gekennzeichnet, dass** es zumindest zwei Netzwerke von Resonatoren im Fluidikkanal umfasst.

9. System nach einem der Ansprüche 7 oder 8, **dadurch gekennzeichnet, dass** es zumindest einen so genannten Referenz-Resonator umfasst, der außerhalb des Fluidikkanals angeordnet ist und an dieselbe Lesevorrichtung wie das im Fluidikkanal angeordnete Netzwerk angeschlossen ist, und dadurch, dass es ein Bearbeitungssystem umfasst, das konfiguriert ist, um das Ausgangssignal des Referenz-Resonators mit den Ausgangssignalen der Resonatorgruppen des Netzwerks zu kombinieren.

10. System nach einem der Ansprüche 7 oder 8, **dadurch gekennzeichnet, dass** das Netzwerk zumindest einen so genannten Referenz-Resonator umfasst, der konfiguriert ist um gegenüber der Gasprobe nicht so empfindlich wie die anderen Resonatorgruppen zu sein, und dadurch, dass das System ein Bearbeitungssystem umfasst, das konfiguriert ist, um das Ausgangssignal des Referenz-Resonators mit den Ausgangssignalen der Resonatorgruppen des Netzwerks zu kombinieren.

# EP 2 904 384 B1

**11.** System nach einem der Ansprüche 1 bis 8, **dadurch gekennzeichnet, dass** es ein Bearbeitungssystem umfasst, das konfiguriert ist, um die Ausgangssignale von jeder Resonatorgruppe des Netzwerks mit einem Durchschnittswert der Signale zu kombinieren.

**12.** System nach einem der Ansprüche 7 bis 11, **dadurch gekennzeichnet, dass** es eine Gaschromatographiesäule, die den Fluidikkanal enthält, umfasst.

**13.** System nach Anspruch 12, **dadurch gekennzeichnet, dass** der Kanal der Chromatographiesäule mehrere Netzwerke von Resonatoren umfasst, die regelmäßig zwischen dem Eingang und dem Ausgang der Säule verteilt sind.

**14.** System nach einem der Ansprüche 7 bis 11, **dadurch gekennzeichnet, dass** es eine Gaschromatographiesäule vor dem Fluidikkanal in der Ausströmrichtung der Gasprobe umfasst.

**15.** Leseverfahren eines Systems nach einem der Ansprüche 1 bis 14, **dadurch gekennzeichnet, dass** es umfasst die Schritte umfasst, die darin bestehen:

> • unter den Resonatorgruppen des Netzwerks, eine zu lesende Resonatorgruppe auszuwählen,
> • im Speicher die Vakuumresonanz-Information von jeder ausgewählten Resonatorgruppe einzuholen,
> • ein Erregersignal an das Netzwerk, das eine Frequenzkomponente umfasst, die mit der Vakuumresonanzfrequenz von jeder ausgewählten Resonatorgruppe übereinstimmt, anzuwenden,
> • die Resonanzfrequenz von jeder ausgewählten Resonatorgruppe zu bestimmen, indem im Ausgangssignal des Netzwerks eine Resonanz-Frequenzkomponente von jeder ausgewählten Resonatorgruppe identifiziert wird.

**16.** Verfahren nach Anspruch 15, **dadurch gekennzeichnet, dass** die Anwendung des Erregersignals im Ausgangssignal eine Hauptfrequenzkomponente generiert, die der Resonanz von jeder ausgewählten Resonatorgruppe entspricht, und dadurch, dass die Resonanzfrequenz von jeder ausgewählten Resonatorgruppe bestimmt wird, indem die Frequenzkomponente dem Ausgangssignal des Netzwerks entnommen wird.

**17.** Herstellungsverfahren eines Systems nach einem der Ansprüche 1 bis 4 **dadurch gekennzeichnet, dass** es die gleichzeitige Herstellung, auf einem Träger aus einem Halbleitermaterial, der das Netzwerk bildenden Resonatoren umfasst, indem mikroelektrische Techniken umgesetzt werden.

**18.** Verfahren nach Anspruch 17, **dadurch gekennzeichnet, dass** es die gleichzeitige Funktionalisierung der Resonatorgruppen des Netzwerks durch chemische Dampfabscheidung (CDV) oder physikalische Dampfabscheidung (PVD) anderer chemischer Spezies für jede der Gruppen umfasst.

**Claims**

**1.** A measurement system comprising a network of nanoelectromechanical system (NEMS) resonators, **characterized in that**:

> • each of said resonators comprises :
>
> > - an input for receiving an excitation signal and an output for supplying an output signal in response to said excitation signal, said output signal exhibiting resonance at the resonant frequency of the resonator,
> > - a beam suspended with respect to a support, the natural resonant frequency of the resonator corresponding to the natural resonant frequency of said beam,
> > - an electrostatic activation device capable of generating a vibration of said beam under the effect of said excitation signal,
> > - at least one piezoresistive strain gauge made of doped semiconductor material, suspended with respect to said support and extending from the beam in such a way as to detect a displacement of said beam, the variation in electrical resistance of said at least one gauge supplying said output signal,
>
> • said network comprises at least two groups of resonators, each group comprising at least two resonators exhibiting an identical natural resonant frequency, each group of resonators exhibiting a different natural resonant frequency from that of each other group,

19

• the system comprises a memory wherein an item of information relating to the natural resonant frequency of each resonator or group of resonators is stored,

• the resonators forming each group are connected in parallel, each group comprising an input and an output respectively connected to the input and output of each of said resonators,

• the groups of resonators forming said network are connected in parallel, said network comprising an input and an output respectively connected to the input and the output of each of said groups of resonators,

• said system comprises a reading device designed to supply an excitation signal to the input of the network and to determine the resonant frequency of a selected group of resonators by injecting into said excitation signal a frequency component corresponding to the natural resonant frequency stored in the memory for each selected group of resonators and by identifying, in the output signal of the network, a frequency component at the resonant frequency of the selected group of resonators.

2. The system according to claim 1, **characterized in that** it comprises a device for summing the output signals of each group of resonators of the network into a total output signal of the network, and **in that** the reading device is designed to determine the resonant frequency of a group of resonators from said total output signal of the network.

3. The system according to claim 2, **characterized in that** said reading device comprises a phase-locked loop (PLL) designed to lock a frequency of the excitation signal onto the frequency of a resonance peak of the output signal of the network and to supply the locked frequency as the excitation resonant frequency.

4. The system according to one of claims 1 to 3, **characterized in that** each group of resonators is functionalized with a different chemical species.

5. The system according to one of claims 1 to 4, **characterized in that** the resonators of the network are arranged on one and the same support in such a way as to form rows and columns of resonators running parallel to one another, the beams of the resonators being parallel to one another.

6. The system according to one of claims 1 to 4, **characterized in that** the resonators of the network are arranged on one and the same support in such a way as to form rows and columns of resonators running parallel to one another, said resonators being further arranged in such a way that, on one and the same row parallel to the beams of the resonators, two adjacent resonators are symmetrical with respect to a plane parallel to a column.

7. The system according to one of claims 1 to 6, **characterized in that** it comprises at least one fluid channel intended for the flow of a gas sample to be analyzed, said network of resonators being arranged in said fluid channel in such a way that the beams of said resonators are exposed to said sample.

8. The system according to claim 7, **characterized in that** it comprises at least two networks of resonators in said fluid channel.

9. The system according to one of claims 7 or 8, **characterized in that** it comprises at least one said reference resonator arranged outside the fluid channel and connected to the same reading device as the network arranged in the fluid channel, and **in that** it comprises a processing system configured to combine the output signal of said reference resonator with the output signals of the groups of resonators of the network.

10. The system according to one of claims 7 or 8, **characterized in that** the network comprises at least one said reference resonator configured to be less sensitive to the gas sample than the other groups of resonators, and **in that** the system comprises a processing system configured to combine the output signal of said reference resonator with the output signals of the groups of resonators of the network.

11. The system according to one of claims 1 to 8, **characterized in that** it comprises a processing system configured to combine the output signals of each group of resonators of the network with a mean of said signals.

12. The system according to one of claims 7 to 11, **characterized in that** it comprises a gas chromatography column containing said fluid channel.

13. The system according to claim 12, **characterized in that** the channel of said chromatography column comprises a plurality of resonator networks distributed regularly between the input and the output of said column.

**14.** The system according to one of claims 7 to 11, **characterized in that** it comprises a gas chromatography column upstream of said fluid channel in the direction of flow of the gas sample.

**15.** A method for reading a system according to one of claims 1 to 14, **characterized in that** it comprises the steps consisting in:

- selecting a group of resonators to be read, from among the groups of resonators of the network,
- retrieving from the memory the natural resonance information of each selected group of resonators,
- applying an excitation signal to the network comprising a frequency component corresponding to the natural resonant frequency of each selected group of resonators,
- determining the resonant frequency of each selected group of resonators by identifying, in the output signal of the network, a resonant frequency component of each selected group of resonators.

**16.** The method according to claim 15, **characterized in that** the application of said excitation signal generates in the output signal a core frequency component corresponding to the resonance of each selected group of resonators, and **in that** the resonant frequency of each selected group of resonators is determined by extracting said frequency component from the output signal of the network.

**17.** A process of fabrication of a system according to one of claims 1 to 14, **characterized in that** it comprises the collective fabrication, on a support made of a semiconductor material, of the resonators forming said network by employing microelectronics techniques.

**18.** The process according to claim 17, **characterized in that** it comprises the collective functionalization of the groups of resonators of said network by chemical vapour deposition (CVD) or physical vapour deposition (PVD) of different chemical species for each of said groups.

## FIG. 1

## FIG. 2

# FIG. 3A

FIG. 3B

FIG. 4

**FIG. 5**

EP 2 904 384 B1

FIG. 6

## FIG. 7

## FIG. 8

## FIG. 9

## FIG. 10

## FIG. 11

NEMS 1 - NEMS 16

## FIG. 12

# FIG. 13A

# FIG. 13B

## FIG. 13C

## RÉFÉRENCES CITÉES DANS LA DESCRIPTION

**Documents brevets cités dans la description**

- US 7750759 B
- US 2009153258 A
- WO 2011154363 A
- EP 2008965 A
- WO 2012034990 A
- WO 2012034951 A
- WO 2011154362 A
- FR 2012050682 W

**Littérature non-brevet citée dans la description**

- **I. BARGATIN ; E.B. MYERS ; J.S. ALDRIDGE ; C. MARCOUX ; P. BRIANCEAU ; L. DURAFFOURG ; E. COLINET ; S. HENTZ ; P. ANDREUCCI ; M.L. ROUKES.** Large-Scale Integration of Nanoelectromechanical Systems for Gas Sensing Applications. *NanoLetters,* 2012, vol. 12, 1269-1274
- **E. MILE ; G. JOURDAN ; I. BARGATIN ; S. LABARTHE ; C. MARCOUX ; P. ANDREUCCI ; S. HENTZ ; C. KHARRAT ; E. COLINET ; L. DURAF-FOURG.** In-plane nanoelectromechanical resona-tors based on silicon nanowire piézorésistives détec-tion. *Nanotechnology,* 2010, vol. 21, 165504